Europäisches Patentamt

European Patent Office

Office européen des brevets

(11) Veröffentlichungsnummer: **0 236 840**
**A2**

(12) **EUROPÄISCHE PATENTANMELDUNG**

(21) Anmeldenummer: **87102599.5**

(22) Anmeldetag: **24.02.87**

(51) Int. Cl.⁴: **H03K 5/153** , H03K 5/19 ,
H02H 9/04 , G01R 29/027

(30) Priorität: **13.03.86 DE 3608440**

(43) Veröffentlichungstag der Anmeldung:
**16.09.87 Patentblatt 87/38**

(84) Benannte Vertragsstaaten:
**AT CH DE FR GB LI NL SE**

(71) Anmelder: **MITEC Moderne Industrietechnik GmbH
Daimlerstrasse 13
D-8012 Ottobrunn(DE)**

(72) Erfinder: **Mehnert,Walter,Dr.Dipl.-Ing.
Grillparzerstrasse 6
D-8012 Ottobrunn(DE)**

(74) Vertreter: **Strasser, Wolfgang, Dipl.-Phys et al
Patentanwälte Strohschänk, Uri & Strasser
Innere Wiener Strasse 8
D-8000 München 80(DE)**

(54) **Impulslängen-Diskriminator.**

(57) Um auch beim häufigen Auftreten von Störsignalen am Eingang (E) eines Impulslängen-Diskriminators eine einwandfreie Diskriminierung und Zuordnung der unterschiedlich langen Nutzimpulse zu verschiedenen, durch die auszulösenden Funktionen zu ermöglichen, ist der Impulslängen-Bewertungsschaltung (1) des Impulslängen-Diskriminators eine Störsignal-Unterdrückungsschaltung vorgeschaltet, die eine Impulspausen-Bewertungsschaltung (8) umfassen kann, welche vorzugsweise als Pausenfalle ausgebildet ist. Dieser Pausenfalle kann noch eine zweite Impulslängen-Bewertungsschaltung (7) zur Unterdrückung kurzer Störimpulse mit kleiner Amplitude sowie eine Potential-Klemmschaltung (6) vorgeschaltet sein, die im signalfreien Zustand alle negativen Störspannungsspitzen und beim Anliegen von Nutzsignalen alle positiven Spannungsspitzen abschneidet und insbesondere die nachfolgenden Bauelemente gegen Überspannungen schützt.

FIG. 1

EP 0 236 840 A2

## Impulslängen-Diskriminator

Die Erfindung betrifft einen Impulslängen-Diskriminator der im Oberbegriff des Anspruches 1 genannten Art.

Solche Impulslängen-Diskriminatoren werden immer dann verwendet, wenn auf einer einzigen Eingangssignalleitung nacheinander eine Vielzahl von Einzelimpulsen teils unterschiedlicher teils gleicher zeitlicher Länge auftritt, die in Abhängigkeit von ihrer zeitlichen Länge in unterschiedlicher Weise weiterverarbeitet, beispielsweise zur Auslösung unterschiedlicher Funktionen verwendet werden sollen.

Im einfachsten Fall, in dem in einer an die Eingangssignalleitung angeschlossenen Empfangsstelle nur eine einzige Funktionsart, beispielsweise das Schließen und Wiederöffnen eines Schalters, immer dann ausgeführt werden soll, wenn ein Impuls empfangen wird, dessen zeitliche Länge über einem vorgegebenen Grenzwert liegt, während alle kürzeren Impulse diese Funktion nicht auslösen sollen, genügt es, wenn die Impulslängen-Bewertungsschaltung des Impulslängen-Diskriminators eine einzige Impulslängen-Bewertungsstufe aufweist, die alle Impulse mit genügend großer Länge "durchläßt" und alle kürzeren Impulse unterdrückt.

Soll in einer Empfangsstelle in Abhängigkeit von der Länge des jeweils empfangenen Einzelimpulses eine von mehreren verschiedenen Funktionsarten ausgeführt werden, so muß die Impulslängen-Bewertungsschaltung des Impulslängen-Diskriminators eine entsprechende Anzahl von Impulslängen-Bewertungsstufen umfassen, die zueinander parallel und/oder seriell angeordnet sein können und von denen jede das Über-oder Unterschreiten eines anderen vorgegebenen Grenzwertes überprüft und immer nur dann ein Ausgangssignal abgibt, wenn die Länge eines empfangenen Einzelimpulses größer als der ihr zugeordnete Grenzwert ist. Alle diese von den verschiedenen Impulslängen-Bewertungsstufen einer solchen Impulslängen-Bewertungsschaltung vorgegebenen Grenzwerte werden im folgenden als "erste" Grenzwerte bezeichnet; sie dienen ausschließlich dazu, Nutzsignalimpulse unterschiedlicher Länge voneinander zu trennen und unterschiedlichen Verwendungen zuzuführen.

Ein Anwendungsbeispiel für einen derartigen Impulslängen-Diskriminator ist in der deutschen Patentanmeldung P 35 26 839.5 beschrieben. Dort werden den Anwähleinheiten einer Meßanordnung auf einer einzigen Kabelader sowohl einzelne Zählals auch einzelne Setzimpulse für einen programmierbaren Adressen-Rückwärtszähler zugeführt, die sich voneinander durch ihre zeitliche Länge unterscheiden. Überdies werden auf derselben Kabelader einzelne Zähl-und Setzimpulse für Adressen-Rückwärtszähler einzelner Meßeinheiten übertragen, die sich sowohl voneinander als auch von den Setz-und Zählimpulsen für die Anwähleinheiten nur durch ihre zeitlich Länge unterscheiden. Da die Anwähleinheiten nicht auf die wesentlich kürzeren Impulse für die Meßeinheiten reagieren sollen, besitzen sie jeweils einen Impulslängen-Diskriminator, der einerseits alle Impulse, die kürzer als der kleinere von zwei vorgegebenen ersten Grenzwerten sind, unterdrückt und alle längeren Impulse anhand eines weiteren vorgegebenen "ersten" Grenzwertes in zwei Klassen unterteilt; die zu der einen Klasse gehörenden Impulse, die kürzer als die zur anderen Klasse gehörenden Impulse sind, dienen dabei der Auslösung der Funktion "Weiterzählen des programmierbaren Rückwärtszählers", während die Impulse der zweiten Klasse die Funktion "Setzen des programmierbaren Rückwärtszählers auf den programmierten Anfangszählwert" auslösen. Ein ähnlicher Impulslängen-Diskriminator ist auch in jeder der Meßeinheiten vorgesehen, denen allerdings die langen Anwähleinheiten-Impulse nicht zugeführt werden, so daß hier nur eine Klassierung der "kurzen" Impulse in "sehr kurze" Zählimpulse und "etwas weniger kurze" Setzimpulse erforderlich ist.

Unter "Einzelimpulsen" sollen im vorliegenden Zusammenhang auch die einzelnen Impulse eines Impuls-Telegramms bzw. eines als Impulsfolge übertragenen Binärwortes verstanden werden, bei dem die einzelnen Binärstellen je nach der übertragenen Information mit Ruhe-oder Arbeitspotential bzw. mit logisch Null oder mit logisch Eins besetzt sein können. In diesen Fällen entstehen unterschiedlich lange "Einzelimpulse" dadurch, daß zwei oder mehr unmittelbar aufeinanderfolgende Binärstellen mit logisch Eins belegt sind, während unterschiedlich lange Pausen dadurch entstehen, daß zwei oder mehr Binärstellen mit logisch Null unmitelbar aufeinanderfolgen. Damit die in einem solchen Binärwort enthaltene Information dekodiert werden kann, ist es erforderlich, mit Hilfe einer Impulslängen-Bewertungsschaltung und einer Pausenlängen-Bewertungsschaltung die unterschiedlichen Impuls-und Pausenlängen zu erfassen und richtig zu klasifizieren.

In dem oben genannten sowie in vielen anderen Anwendungsfällen ergibt sich jedoch das Problem, daß auf der die Nutzimpulse übertragenden Signaleitung Störsignale auftreten, die meist durch induktive Einkopplung entstehen und Spannungsspitzen bzw. Impulse verursachen, die bezogen auf das Ruhepotential der Signalleitung, das dem Logikwert "Null" der Nutzimpulse entspricht und beispielsweise gleich dem Massepotential sein kann, sowohl positiv als auch negativ sein können. Es hat sich gezeigt, daß bei langen Signalleitungen und/oder in einer stark mit Störsignalen "verunreinigten" Umgebung, beispielsweise in Kraftfahrzeugen, diese Störsignale den Empfang und die Diskriminierung und Zuordnung der Nutzimpulse zu den verschiedenen, durch sie auszulösenden Funktionsarten schwierig oder sogar unmöglich machen.

Demgegenüber liegt der Erfindung die Aufgabe zugrunde, einen Impulslängen-Diskriminator der eingangs genanten Art zu schaffen, der in der Lage ist, Nutzimpulse unterschiedlicher Länge auch dann noch einwandfrei zu verarbeiten und je nach ihrer zeitlichen Länge den verschiedenen Funktionsarten richtig zuzuordnen, wenn die Eingangssignalleitung, auf der die Nutzsginalimpulse empfangen werden, stark mit Störsignalen "verseucht" ist.

Zur Lösung dieser Aufgabe sieht die Erfindung die im Anspruch 1 zusammengefaßten Merkmale vor.

Diesen erfindungsgemäßen Maßnahmen liegt die Überlegung zugrunde, daß das Spektrum der auf die Signalleitung eingekoppelten Störimpulse im allgemeinen eine untere Frequenzgrenze besitzt, unterhalb derer das Auftreten von Störsignalen sehr unwahrscheinlich ist. In den Fällen, in denen nur die Impulse, deren zeitliche Länge größer als ein einziger vorgebbarer "erster" Grenzwert ist, eine einzige Funktion auslösen sollen, während alle kürzeren Impulse unterdrückt werden, wird man diesen Grenzwert so wählen, daß er deutlich größer als der Kehrwert der oben genannten Frequenzgrenze ist. Für die Fälle, in denen mehrere Nutzimpulsarten unterschiedlicher Länge mehrere verschiedene Funktionen auslösen sollen, in denen also mehrere "erste" Grenzwerte vorgegeben werden müssen, wird man den kleinsten dieser "ersten" Grenzwere so wählen, daß er deutlich größer als der oben genannte Kehrwert ist. Durch die Erzeugung entsprechend langer Nutzimpulse kann dann erreicht werde, daß die kürzesten Nutzimpulse länger als die längsten zu erwartenden Störsignale sind und daher mit Hilfe einer Störsignal-Unterdrückungsanordnung von diesen getrennt werden können.

Ein erster Schritt zur Durchführung dieser Trennung besteht gemäß der Erfindung darin, daß die der Impulslängen-Bewertungsschaltung vorgeschaltete Störsignal-Unterdrückungsanordnung eine Impulspausen-Bewertungsschaltung umfaßt, mit deren Hilfe die Länge der jeweils zwischen zwei aufeinanderfolgenden Impulsen auftretenden Pausen erfaßt und zu einer Aussage darüber herangezogen werden kann, ob die beiden Impulse "echte" Störimpulse sind oder ob es sich bei ihnen um die Teile eines Nutzimpulses handelt, der durch Störsignal zerhackt worden ist. Letztere Erscheinung tritt dann auf, wenn es in den Zeiten, in denen auf der Eingangssignalleitung des Impulslängen-Diskriminators Nutzimpulse übertragen werden, zur Einkoppelung von Störsignalen kommt, die ein zum Vorzeichen der Nutzimpulse entgegengesetztes Vorzeichen aufweisen. Diese Störsignale können die Nutzimpulse in zwei oder mehr Teilimpulse "zerhacken", deren zeitliche Länge jeweils kleiner als der (kleinste) "erste" Grenzwert ist, so daß sie von der Impulslängen-Bewertungsschaltung irrtümlich für Störimpulse gehalten und unterdrückt werden.

Um diese Störungsart weitgehend auszuschalten, ist bei einer bevorzugten Weiterbildung des erfindungsgemäßen Impulslängen-Diskriminators vorgesehen, daß die Impulspausen-Bewertungsschaltung als "Pausenfalle" aufgebaut ist, d.h. alle Impulspausen eliminiert, deren zeitliche Länge kleiner als ein zweiter vorgebbarer Grenzwert ist, der kleiner als der (kleinste) "erste" Grenzwert, vorzugsweise etwa gleich 50 % des - (kleinsten) ersten Grenzwertes gewählt wird. Diese Pausenfalle gibt also z.B. auch dann nur einen einzigen Ausgangsimpuls mit entsprechend großer Länge ab, wenn ihr zwei oder mehr kurze Einzelimpulse nacheinander zugeführt werden, die durch eine oder mehrere Pausen voneinander getrennt sind, die jeweils kürzer als der zweite Grenzwert sind. Ein durch Störsignale "zerhackter" Nutzimpuls wird somit durch die Pausenfalle wieder in einen einzigen langen Impuls verwandelt, der von der nachgeschalteten Impulslängen-Bewertungsschaltung richtig erkannt und zugeordnet werden kann.

Beim Auftreten einer besonders ungünstigen Konstellation von Störsignalen, nämlich dann, wenn im nutzsignalfreien Zustand der Eingangssignalleitung kurz hintereinander mehrere Störimpulse eingekoppelt werden, deren zeitlicher Abstand kleiner als der zweite Grenzwert ist, besteht jedoch die Gefahr, daß die Pausenfalle aus diesen Störimpulsen einen Pseudo-Nutzimpuls aufbaut, der länger als der (kleinste) erste Grenzwert ist und daher irrtümlich zur Auslösung der entsprechenden Funktion zugelassen wird.

Um diese Gefahr möglichst klein zu halten, ist bei einer weiteren, besonders bevorzugten Ausführungsform eines erfindungsgemäßen Impulslängen-Diskriminators vorgesehen, der Pausenfalle eine zweite Impulslängen-Bewertungsschaltung vorzuschalten, die alle Impulse unterdrückt, deren zeitliche Länge kleiner als ein dritter vorgebbarer Grenzwert ist, der kleiner als der zweite Grenzwert und vorzugsweise etwa gleich 10 % des (kleinsten) ersten Grenzwertes gewählt wird.

Dieser Maßnahme liegt die Erkenntnis zugrunde, daß inbesondere bei induktiver Störungseinkopplung die Abstände von im nutzsignalfreien Zustand auftretenden Störimpulsen in der gleichen Größenordnung liegen wie die zeitliche Länge dieser Impulse. Das bedeutet, daß Störimpulse, deren zeitliche Abstände so kurz sind, daß die Gefahr einer irrtümlichen Erzeugung eines Pseudo-Nutzimpulses durch die Pausenfalle besteht, eine kurze zeitliche Länge besitzen und daher durch die zweite Impulslängen-Bewertungsschaltung weitgehend unterdrückt werden können, bevor sie an den Eingang der Pausenfalle gelangen. Somit kann die Pausenfalle auf diese kurzen Störimpulse nicht ansprechen und die Gefahr der irrtümlichen Erzeugung eines Pseudo-Nutzimpulses wird in sehr starkem Maße verringert. Außerdem bewirkt diese zweite Impulslängen-Bewertungsschaltung, daß die nachfolgenden Schaltungseinheiten nur bei solchen Impulsen ansprechen, die länger als der dritte Grenzwert sind, während sie bei allen kürzeren Impulsen desaktiviert bleiben. Durch diese Verringerung der Ansprechhäufigkeit läßt sich insbesondere bei der Verwendung von CMOS-Schaltkreisen eine erhebliche Reduzierung des Stromverbrauchs erzielen.

Gemäß einer weiteren bevorzugten Ausführungsform besitzt die Störsignal-Unterdrückungsanordnung als Eingangsglied einen Schmitt-Trigger, dem die Eingangssignale des Impulslängen-Diskriminators zugeführt werden und dessen Einschaltschwelle sehr dicht an das Arbeitspotential der Nutzimpulse, bei positiven Nutzimpulsen also auf einen Spannungswert gelegt wird, der nur wenig kleiner als der dem Logikpegel 1 entsprechende Spannungswert ist.

Dieser Maßnahme liegt die Überlegung zugrunde, daß nieder-und mittelfrequente Störsignale, d.h. insbesondere Störimpulse, die von der zweiten Impulslängen-Bewertungsschaltung durchgelassen werden, im allgemeinen nicht genügend Energie besitzen, um die Spannung am Eingang des Impulslängen-Diskriminators auf das Arbeitspotential der Nutzimpulse zu bringen. Sie haben also im Regelfall deutlich kleinere Amplituden als die Nutzimpulse und können daher mit Hilfe des erwähnten Schmitt-Triggers unterdrückt werden, bevor sie an die zweite Impulslängen-Bewertungsschaltung gelangen.

Eine weitere Verbesserung der Unterscheidungsmöglichkeiten zwischen Stör-und Nutzsignalen läßt sich dadurch erreichen, daß die Spannung am Eingang des Impulslängen-Diskriminators mit Hilfe einer Potential-Klemmschaltung daran gehindert wird, im nutzsignalfreien Zustand in merklicher Weise vom Ruhepotential in einer Richtung abzuweichen, die der Richtung der durch die Nutzsignale bewirkten Spannungsänderung entgegengesetzt ist. Sind die Nutzimpulse also z.B. positiv gegenüber einem dem Massepotential entsprechenden Ruhepotential, so wird der Eingang des Impulslängen-Diskriminators durch die Potential-Klemmschaltung daran gehindert, gegenüber dem Massepotential in merklicher Weise negativ zu werden. Die Potential-Klemmschaltung kann vorzugsweise so weitergebildet werden, daß sie beim Anliegen von z.B. positiven Nutzimpulsen verhindert, daß das Potential am Eingang des Impulslängen-Diskriminators merklich über das Arbeitspotential der Nutzimpulse ansteigt. Hierdurch wird erreicht, daß im nutzsignalfreien Zustand nur Störimpulse auftreten können, die das gleiche Vorzeichen wie die Nutzimpulse aufweisen, während beim Anliegen von Nutzimpulsen nur Störungen in Form von Impulspausen auftreten können. Überdies werden durch eine solche Potential-Klemmschaltung, die vorzugsweise von zwei entsprechend gepolten Dioden gebildet wird, die mit der Eingangs-Signalleitung verbundenen Bauelemente gegen Überspannungen geschützt, so daß der erfindungsgemäße Impulslängen-Diskriminator ohne weiteres mit CMOS-Schaltkreisen aufgebaut werden kann, die zwar in dieser Hinsicht besonders empfindlich sind, andererseits aber den Vorteil einer äußerst geringen Stromaufnahme bieten.

Während der zeitbestimmende Teil der zweiten Impulslängen-Bewertungsschaltung vorzugsweise als Analogschaltung aufgebaut wird, können die zeitbestimmenden Teile der Pausenfalle und/oder der ersten Impulslängen-Bewertungsschaltung erfindungsgemäß entweder als Analogschaltungen oder als Digitalschaltungen aufgebaut werden; im letzteren Fall werden die betreffenden Grenzwerte vorzugsweise dadurch vorgegeben, daß entsprechende Zählwerte von Zählern dekodiert werden, die die Taktimpulse eines Oszillators abzählen, der mit einer fest vorgegebenen, bekannten Frequenz - schwingt. Um den Stromverbrauch einer solchen digitalen Schaltung möglichst klein zu halten, ist vorzugsweise vorgesehen, daß der Oszillator "normalerweise" nicht schwingt und nur dann zum Schwingen freigegeben wird, wenn am Ausgang der zweiten Impulslängen-Be wertungsschaltung ein weiterzuverarbeitender Impuls erscheint. Ein weiterer Vorteil dieser digitalen Schaltung besteht darin, daß die bei Analogschaltungen benötigten Kondensatoren, die in integrierter Schaltungstechnik schwer herstellbar sind und daher in der Regel extern zugeschaltet werden müssen, weitgehend vermieden werden. Andererseits besitzen die Analogschaltungen den Vorteil, daß die durch die definierten Zeiträume nicht dadurch in ungünstiger Weise verfälscht werden können, daß eine in einen solchen Zeitraum nur teilweise eingehende Oszillatorschwingung als ganze Schwingung gezählt wird, was z.B. bei einer Schwingungsfrequenz von 1OO kHz im ungünstigsten Fall zu einem Fehler von 1Oµs führen kann.

Die zeitbestimmenden Teile insbesondere der beiden Impulslängen-Bewertungsschaltungen können im einfachsten Fall aus einem Verzögerungsglied, z.B. einer Verzögerungsleitung, und einem UND-Gatter aufgebaut werden, wobei die zu bewertenden Impulse dem einen Eingang des UND-Gatters direkt und dem anderen Eingang des UND-Gatters über das Verzögerungsglied zugeführt werden, dessen Verzögerungszeit dann den betreffenden Grenzwert im wesentlichen bestimmt. Wenn diese Grenzwerte aber vergleichsweise groß gewählt werden sollen, ergeben sich unter Umständen Schwierigkeiten mit der Baulänge der hierfür benötigten Verzögerungsleitungen. Insbesondere in diesen Fällen wird als zeitbestimmender Teil dann jeweils ein integrierendes RC-Glied verwendet, dem ein Schmitt-Trigger zur Regenierung steiler Impulsflanken nachgeschaltet ist.

Die Erfindung wird im folgenden anhand von Ausführungsbeispielen unter Bezugnahme auf die Zeichnung beschrieben; in dieser zeigt:

Fig. 1 eine erste Ausführungsform eines erfindungsgemäßen Impulslängen-Diskriminators, bei der die Dignalverarbeitung teilweise analog und teilweise digital vorgenommen wird,

Fig. 2 ein Signaldiagramm zur Erläuterung der Funktionsweise des Impulslängen-Diskriminators aus Fig. 1,

Fig. 3 eine zweite Ausführrungsform eines erfindungsgemäßen Impulslängen-Diskriminators, bei der die Signalverarbeitung rein digital erfolgt, und

Fig. 4 ein Signaldiagramm zur Erläuterung der Funktionsweise des Impulslängen-Diskriminators aus Fig. 3.

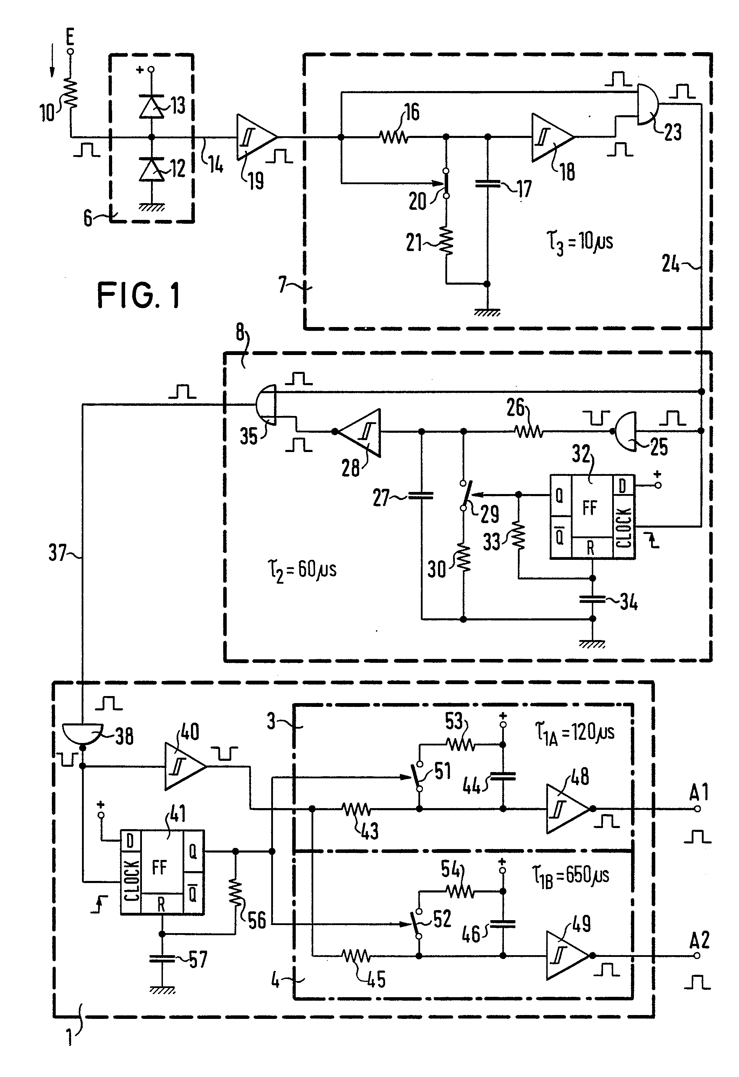

Der in Fig. 1 wiedergegebene Impulslängen-Diskriminator besitzt eine erste Impulslängen-Bewertungsschaltung 1, die zwei zueinander parallel angeordnete Impulslängen-Bewertungsstufen 3 und 4 unfaßt. Die Stufe 3 gibt an ihrem Ausgang A1 immer dann ein impulsförmiges Signal ab, wenn am Eingang E des Impulslängen-Diskriminators ein Impuls aufgetreten ist, dessen zeitliche Länge größer als ein erster vorgegebener Grenzwert $\tau_{1A}$ ist, der hier gleich 12Oµs gewählt wurde. Die Stufe 4 gibt dagegen an ihrem Ausgang A2 immer dann ein impulsförmiges Signal ab, wenn am Eingang E ein Impuls erscheint, dessen zeitliche Länge größer als ein weiterer vorgebbarer erster Grenzwert $\tau_{1B}$ ist, der im vorliegenden Fall gleich 65Oµs ist.

Damit die erste Impulslängen-Bewertungsschaltung 1 auch dann noch die dem Impulslängen-Diskriminator am Eingang E zugeführten Impulse einwandfrei verarbeiten kann, wenn auf die am Eingang E anliegenden Nutzsignale Störsignal aufgeprägt sind, von denen angenommen wird, daß ihre Folgefrequenz bzw. Impulsbreite deutlich kleiner als die Folgefrequenz bzw. Impulsbreite der Nutzsignale ist, ist der ersten Impulslängen-Bewertungsschaltung 1 eine Störsignal-Unterdrückungsanordnung vorgeschaltet, die aus einer Dioden-Klemmschaltung 6, einer zweiten Impulslängen-Bewertungsschaltung 7 und einer als Pausenfalle ausgebildeten Impulspausen-Bewertungsschaltung 8 besteht.

Die am Eingang E anliegenden Nutzsignal-Impulse, von denen angenommen wird, daß ihr Ruhepotential, das im folgenden auch als logisch Null bezeichnet wird, gleich dem Massepotential ist, und daß ihr Arbeitspotential, das im folgenden auch als logisch Eins bezeichnet wird, gleich einer gegenüber der Masse positiven Spannung ist, werden der Dioden-Klemmschaltung 6 über einen Widerstand 1O zugeführt. Dieser Widerstand ist beispielsweise für die Anwendung eines solchen Impulslängen-Diskriminators in einem Meßkabel von Bedeutung, wie es in der deutschen Patentanmeldung P 35 26 839.5 beschrieben ist. Bei einer solchen Anordnung umfaßt jede Anwahlschaltung und jede Meßstelle einen Impulslängen-Diskriminator der hier beschriebenen Art, der in Form einer integrierten Halbleiterschaltung aufgebaut ist. Der Widerstand 1O dient dazu, die Betriebssicherheit des Systems zu erhöhen, indem er den in den Eingang E fließenden Strom auf einen tragbaren Wert begrenzt, wenn es im Inneren des Impulslängen-Diskriminators zu einem Kurzschluß zur Masse hin kommt.

Die Dioden-Klemmschaltung 6 besteht aus zwei gleichsinnig miteinander in Reihe geschalteten Dioden 12, 13, deren Verbindungspunkt mit der Signalleitung 14 verbunden ist, während die Anode der Diode 12 mit dem Ruhepotential der Nutzsignalimpulse, d.h. im vorliegenden Fall mit dem Massepotential und die Kathode der Diode 13 mit dem positiven Arbeitspotential der Nutzsignalimpulse verbunden ist.

Insbesondere bei dem oben erwähnten, bevorzugten Anwendungsfall des erfindungsgemäßen Impulslängen-Diskriminators in einem Meßkabel ist davon auszugehen, daß die am Eingang E erscheinenden Störsignale durch induktive Einkopplung enstanden sind und somit aus Spannungsspitzen bzw. -impulsen bestehen, die gegenüber dem Massepotential abwechselnd positiv und negativ sind. Durch die Dioden-Klemmschaltung 6 werden alle im signalfreien Zustand auftretenden negativen Spannungsspitzen durch die Diode 12 kurzgeschlossen. Positive Störspannungs-Spitzen bzw. -impulse können dagegen über einen Schmit-Trigger 19 an die nachfolgende zweite Impulslängen-Bewertungsschaltung 7 gelangen. Liegt dagegen am Eingang E ein Nutzsignal-Impuls an, so verhindert die Diode 13, daß das positive Arbeitspotential dieses Impulses beim Auftreten positiver Störspannungs-Spitzen weiter ansteigen kann. Negative Störspannungs-Spitzen können dagegen beim Anliegeneines solchen Nutzsignals das Potential auf der Signalleitung 14 nach unten ziehen, so daß ein Nutzsignalimpuls, der eigentlich eine zeitliche Länge von 120$\mu$s oder 650$\mu$s aufweist, in zwei oder mehr wesentlich kürzere Impuls "zerhackt" wird. Ohne weitere Maßnahmen könnte er dann von den beiden Stufen 3 und 4 der ersten Impulslängen-Bewertungsschaltung 1 nicht mehr als Nutzimpuls erkannt werden.

Um dies zu verhindern, überbrückt, wie dies weiter unten noch genauer erläutert wird, die Impulspausen-Falle 8 alle zwischen zwei aufeinanderfolgenden Impulsen auftretenden Lücken bzw. Pausen, wenn die zeitliche Länge jeder dieser Pausen einen zweiten vorgebbaren Grenzwert $\tau_2$ nicht übersteigt, der im vorliegenden Fall gleich 60$\mu$s gewählt wurde. Ohne weitere Maßnahmen hätte dies allerdings zur Folge, daß eine im signalfreien Zustand am Eingang E auftretende Vielzahl von kurz hintereinander folgenden positiven Störsignalimpulsen durch die Pausenfalle 8 in einen einzigen langen Impuls umgewandelt würde, der im ungünstigsten Fall die Länge eines Nutzsignalimpulses erreichen, d.h. zumindest den kleineren der beiden ersten Grenzwerte $\tau_{1A}$überschreiten könnte.

Um dies zu verhindern, ist zwischen der Dioden-Klemmschaltung 6 und der Pausenfalle 8 eine zweite Impulslängen-Bewertungsschaltung 7 vorgesehen, die alle positiven Eingangssignale unterdrückt, deren zeitliche Länge kleiner als ein dritter vorgebbarer Grenzwert $\tau_3$ ist, der im vorliegenden Fall gleich 10$\mu$s gewählt wurde.

Wie Fig. 1 zeigt, besitzt die zweite Impulslängen-Bewertungsschaltung 7 als zeitbestimmendes Element ein RC-Glied, das aus einem Ladewiderstand 16 und einem Kondensator 17 besteht und dessen Zeitkonstante den dritten Grenzwert $\tau_3$ festlegt. Der eine Anschluß des Kondensators 17 ist mit dem Massepotential verbunden, während sein anderer Anschluß einerseits mit dem Ladewiderstand 16 und andererseits mit dem Eingang eines Schmitt-Triggers 18 verbunden ist, der die durch das RC-Glied 16, 17 abgeflachten Pegelübergänge wieder in steile Impulsflanken verwandelt. Dem zweiten, als Signaleingang des RC-Gliedes 16, 17 dienenden Anschluß des Ladewiderstandes 16 werden die auf der Signalleitung 14 erscheinenden Signale über einen der zweiten Impulslängen-Bewertungsschaltung 7 vorgeschalteten Schmitt-Trigger 19 zugeführt, der dazu dient, insbesondere mittel-und niederfrequente Störimpulse zu unterdrücken, deren Amplitude kleiner als die der Nutzimpulse ist. Zu diesem Zweck ist die Einschaltschwelle des Schmitt-Triggers 19 so gewählt, daß sie knapp unter dem Arbeitspotential der Nutzimpulse liegt und somit im wesentlichen nur von letzteren überwunden werden kann. Aber auch solche mittel-und nieder frequenten Störimpulse, deren Amplitude ausreicht, um die Einschaltschwelle des Schmitt-Triggers 19 zu überwinden, werden durch diesen Schmitt-Trigger 19 beträchtlich verkürzt, da er erst auf das Ende ihrer langsam ansteigenden Vorderflanke reagiert. Hierdurch steigt die Wahrscheinlichkeit, daß derartige Impulse so verkürzt werden, daß sie entweder von der nachfolgenden zweiten Impulslängen-Bewertungsschaltung 7 unterdrückt werden oder daß die Pausen zwischen ihnen so vergrößert werden, daß die Pausenfalle 8 diese Pausen nicht mehr überbrückt und die erste Impulslängen-Bewertungsschaltung 1 die betreffenden Impulse endgültig unterdrückt.

Parallel zum Kondensator 17 ist eine aus einem steuerbaren Schalter 20 und einem Entladewiderstand 21 bestehende Serienschaltung angeordnet. Der Widerstandswert des Entladewiderstandes 21 ist wesentlich, d.h. beispielsweise um einen Faktor 100, kleiner gewählt, als der Widerstandswert des Ladewiderstandes 16. Der Schalter 20 wird durch das Ausgangssignal des zweiten Schmitt-Triggers 19 so gesteuert, daß er im signalfreien Zustand geschlossen und beim Anliegen eines positiven Impulses geöffnet ist. Auf diese Weise kann der Kondensator 17 am Ende eines jeden Impulses sehr schnell wieder entladen werden, do daß auch dann, wenn der zweiten Impulslängen-Bewertungsschaltung 7 sehr schnell hintereinander kurze Impulse zugeführt werden, für jeden dieser Impulse die volle Zeitkonstante $\tau_3$ zur Verfügung steht und nicht durch Restladungen, die von vorausgehenden Impulsen im Kondensator 17 verblieben sind, verkürzt wird.

Der Ausgang des Schmitt-Triggers 18 steuert den einen Eingang eines UND-Gatters 23 an, dessen zweiter Eingang direkt mit dem Ausgang des zweiten Schmitt-Triggers 19 verbunden ist. Dieses UND-Gatter 23 gibt erst dann einen positiven Ausgangsimpuls ab, wenn die zeitliche Länge eines vom Schmitt-Trigger 19 abgegebenen positiven Impulses größer als die Zeitkonstante $\tau_3$ war, d.h. wenn der Kondensator 17 über den Ladewiderstand 16 so weit auf ein positives Potential aufgeladen wurde, daß der zunächst an seinem Ausgang eine logische Null abgebende erste Schmitt-Trigger 18 ebenfalls auf logisch Eins umgeschaltet hat. Alle kürzeren Impulse werden von der zweiten Impulslängen-Bewertungsschaltung 7 unterdrückt und gelangen nicht an die nachfolgende Pausenfalle 8. Am Anfang eines jeden genügend langen vom zweiten Schmitt-Trigger 19 abgegebenen Impulses schaltet das UND-Gatter 23 praktisch gleichzeitig mit dem Schmitt-Trigger 18. Lediglich am Ende eines solchen Impulses schaltet das UND-Gatter sofort, während der Schmitt-Trigger 18 an seinem Ausgang erst dann wieder auf logisch Null zurückfällt, wenn der Kondensator 17 über den geschlossenen Schalter 20 und den Entladewiderstand 21 genügend weit entladen ist. Bei dem oben erwähnten, bevorzugten Anwendungsfall wird der Impulslängen-Diskriminator vorzugsweise als integrierte Schaltung in C-MOS-Technologie aufgebaut. Die in dieser Technologie herstellbaren, steuerbaren Schalter besitzen auch im geschlossenen Zustand einen erheblichen Restwiderstand, der innerhalb weiter Grenzen schwanken kann. Das UND-Gatter 23 sorgt dafür, daß die fallende Flanke eines vom Schmitt-Trigger 19 abgegebenen Impulses sofort an die nachfolgende Pausenfalle 8 weitergegeben und nicht einer wegen des nicht genau bekannten Restwiderstandes des Schalters 20 ebenfalls nicht genau bekannten Verzögerung unterworfen wird.

Die Ausgangsimpulse der zweiten Impulslängen-Bewertungsschaltung 7 werden über die Signalleitung 24 und einen Inverter 25 dem aus einem Ladewiderstand 26 und einem Kondensator 27 bestehenden RC-Glied der Pausenfalle 8 zugeführt. Die Ausgangssignale dieses RC-Glieds werden durch einen invertierenden Schmitt-Trigger 28 wieder in Rechtecksimpulse umgesetzt. Parallel zum Kondensator 27 des RC-Glieds sind wieder ein steuerbarer Schalter 29 und ein mit diesem Schalter 29 in Reihe liegender Entladewiderstand 30 angeordnet. Der Widerstandswert des Entladewiderstandes 30 ist wieder wesentlich kleiner als der Widerstandswert des Ladewiderstands 26, so daß der Kondensator 27 in einer im Vergleich zu seiner Ladezeit $\tau_2$ sehr kurzen Zeit entladen werden kann. Sinn dieser Entladung ist es, auch bei kurz hintereinanderfolgenden Impulspausen für jede dieser Pausen die volle Zeitkonstant des RC-Gliedes zur Verfügung zu haben. Die Entladung erfolgt zu Beginn eines jeden auf der Signalleitung 24 erscheinenden Impulses mit Hilfe eines als Monoflop arbeitenden Flip-Flops 32, dessen Takteingang mit der Signalleitung 24 verbunden ist und auf die steigende Flanke der dort erscheinenden Impulse reagiert. Der D-Eingang des Flip-Flops 32 liegt ständig auf positivem Potential, so daß bei Triggerung des Flip-Flops 32 über seinen Takteingang an seinem Q-Ausgang eine logische Eins erscheint. Diese logische Eins schließt einerseits den Schalter 29 und lädt andererseits über einen Widerstand 33 einen zuvor entladenen Kondensator 34, der mit seinem mit dem Widerstand 33 verbundenen Anschluß mit dem Rücksetzeingang des Flip-Flops 32 verbunden ist. Somit wird die nach dem Setzen des Flip-Flops 32 am Q-Ausgang erschienene logische Eins nach einem durch die Zeitkonstante des RC-Gliedes 33, 34 vorgegebenen Zeitraum an den Rücksetzeingang des Flip-Flops 32 weitergegeben, so daß sich das Flip-Flop selbst zurücksetzt. Die Zeitkonstante des RC-Gliedes 33, 34 ist so gewählt, daß sie mit Sicherheit größer ist als die Entlade-Zeitkonstante des Kondensators 27 über den steuerbaren Schalter 29 und den Entladewiderstand 30. Der Schalter 29 bleibt also nach Auftreten eines Impulses auf der Signalleitung 24 mit Sicherheit so lange geschlossen, bis der im signalfreien Zustand vollständig geladene Kondensator 27 mit Sicherheit völlig entladen ist. Die steigende Flanke eines auf der Signalleitung 24 erscheinenden positiven Impulses wird also durch das Schließen des Schalters 29 sehr schnell als fallende Flanke an den invertierenden Schmitt-Trigger 28 weitergegeben, dessen Ausgangssignal hierauf von einer logischen Null auf eine logische Eins übergeht. Der Ausgang des Schmit-Triggers 28 steuert den einen Eingang eines ODER-Gatters 35 an, dessen anderer Eingang unmittelbar mit der Signalleitung 24 verbunden ist. Dieses ODER-Gatter dient ähnlich wie das oben beschriebene UND-Gatter 23 dazu, die vordere Flanke eines auf der Signalleitung 24 erscheinenden Impulses sofort auf die zur ersten Impulslängen-Bewertungsschaltung 1 führende Signalleitung 37 weiterzugeben, so daß für diese Flanke unbekannte Verzögerungen, die durch den unbekannten Restwiderstand des geschlossenen Schalters 29 entstehen können, keine Rolle spielen.

Da die Zeitkonstante des RC-Gliedes 33, 34 sehr kurz gewählt ist, wird der Schalter 29 sehr rasch wieder geöffnet. Wird nach diesem Zeitpunkt der auf der Signaleitung 24 erschienene Impuls beendet, so erscheint am Ausgang des Inverters 25 ein posives Potential, das über den Ladewiderstand 26 den Kondensator 27 langsam auflädt. Ist die zwischen dem soeben beendeten Impuls und dem nachfolgenden Impuls vorhandene Pause länger als der durch die Zeitkonstante des RC-Gliedes 26, 27 festgelegte zweite Grenzwert $\tau_2$, der im vorliegenden Fall 60$\mu$s beträgt, so erreicht, das Potential am Eingang des invertierenden Schmitt-Triggers 28 einen Wert, der den Ausgang dieses Schmitt-Triggers wieder auf logisch Null zurückschalten läßt. Da durch die bereits zuvor stattgefundene Beendigung des auf der Leitung 24 erschienen Impulses nunmehr beide Eingänge des ODER-Gatters 35 auf logisch Null liegen, wird auch der auf die Leitung 37 abgegebene Impuls beendet.

Ist dagegen die Pause oder Lücke zwischen zwei aufeinanderfolgenden Impulsen auf der Signalleitung 24 kürzer als der zweite Grenzwert $\tau_2$, so verschwindet zwar bei Beendigung des ersten dieser beiden Impulse die logische Eins an dem einen Eingang des ODER-Gatters 35 aber die logische Eins am Ausgang dieses Gatters wird durch das weiterhin auf logisch Eins liegende Ausgangssignal des invertierenden Schmitt-Triggers 28 aufrechterhalten. Da in diesem Fall auf der Signalleitung 24 ein neuer Impuls auftritt, durch dessen steigende Flanke das Flip-Flop 32 getriggert, der Schalter 29 geschlossen und der Kondensator 27 wieder vollständig entladen wird, bevor der Ausgang des Schmitt-Triggers 28 von logisch Eins auf logisch Null abgefallen ist, ändert sich am Ausgangssignal des ODER-Gatters 35 nichts. Die zwischen den beiden aufeinanderfolgenden Impulsen vorhandene Pause, die $\leq 60\mu s$ war, wird also am Ausgang des ODER-Gatters 35 unterdrückt. Statt der beiden voneinander getrennten Impulse auf der Signalleitung 24 erscheint auf der Signalleitung 37 ein einziger, über das Ende des zweiten der beiden Impulse um die Zeitkonstante $\tau_2$ hinaus verlängerter Impuls.

Die auf der Signalleitung 37 erscheinenden Impulse werden der ersten Impulslängen-Bewertungsschaltung 1 über einen Inverter 38 zugeführt, dessen Ausgang einerseits den Eingang eines zur Signalformung dienenden Schmitt-Triggers 40 und andererseits den Takteingang eines als Monoflop geschalteten Flip-Flops 41 ansteuert.

Der Ausgang des Schmitt-Triggers 40 steuert parallel die Eingänge der beiden Impulslängen-Bewertungsstufen 3, 4 an, von denen jede ein RC-Glied 43, 44 bzw. 45, 46 und einen die Ausgangssignale des zugehörigen RC-Gliedes in Rechtecks-Impulse umsetzenden, invertierenden Schmitt-Trigger 48 bzw. 49 umfaßt. Die Zeitkonstanten der beiden RC-Glieder 43, 44 bzw. 45, 46 sind so gewählt, daß am Ausgang A1 der Stufe 3 nur dann ein Ausgangsimpuls erscheint, wenn der der Impulslängen-Bewertungsschaltung 1 zugeführte Eingangsimpuls länger als $120\mu s$ ist, und daß am Ausgang A2 der Stufe 4 nur dann ein Ausgangsimpuls erscheint, wenn der der Impulslängen-Bewertungsschaltung 1 zugeführte Impuls länger als $650\mu s$ ist.

Parallel zu jedem der beiden Kondensatoren 44, 46 ist wieder ein steuerbarer Schalter 51 bzw. 52 und ein mit diesem Schalter jeweils in Reihe liegender Entladewiderstand 53 bzw. 54 angeordnet. Die Widerstandswerte der Entladewiderstände 53, 54 sind auch hier wieder wesentlich kleiner gewählt als die Widerstandswerte der beiden zugehörigen Ladewiderstände 43 bzw. 45.

Die beiden Schalter 51, 52 sind normalerweise geöffnet und werden lediglich am Ende eines jeden auf der Signalleitung 37 erscheinenden Impulses kurzzeitig solange geschlossen, bis die beiden Kondensatoren 44, 46 mit Sicherheit vollständig entladen sind. Damit wird auch hier sichergestellt, daß auch dann, wenn der ersten Impulslängen-Bewertungsschaltung 1 sehr schnell hintereinander mehrere Impulse zugeführt werden, für jeden dieser Impulse jeweils die volle Zeitkonstante des betreffenden RC-Gliedes zur Verfügung steht und nicht durch Restladungen verkürzt wird, die von vorausgehenden Impulsen im Kondensator 44 bzw. 46 verblieben sind. Zu diesem Zweck werden die Schalter 51, 52 vom Q-Ausgang des Flip-flops 41 angesteuert, das durch die steigende Flanke, die der Inverter 38 am Ende eines jeden auf der Leitung 37 erscheinenden Impulses abgibt, gesetzt wird und sich selbst nach einem durch die Zeitkonstante des RC-Gliedes 56, 57 definierten Zeitraum zurücksetzt. Diese Zeitkonstante ist in entsprechender Weise gewählt, wie dies oben für die Zeitkonstante des RC-Gliedes 33, 34 beschrieben wurde.

Im Gegensatz zu den beiden Kondensatoren 17 und 27 der entsprechenden RC-Glieder der zweiten Impulslängen-Bewertungsschaltung 7 und der Impulspausen-Unterdrückungsschaltung 8 sind die beiden Kondensatoren 44, 46 mit dem einen ihrer beiden Anschlüsse nicht auf Masse sondern auf Plus-Potential gelegt, das in diesem Fall das Ruhe-Potential darstellt.

Diese andere Schaltungsart hängt lediglich von den hier verwendeten Signalpegeln ab. Verwendet man als Schmitt-Trigger 40 einen invertierenden Schmitt-Trigger, so sind die beiden Kondensatoren 44 und 46 ebenso zu schalten, wie dies oben für die Kondensatoren 17 und 27 wiedergegeben ist. In diesem Fall werden dann, wenn man an den Ausgängen A1 und A2 positive Impulse erzielen möchte, für die Schmitt-Trigger 48 und 49 nichtinvertierende Bauelemente verwendet. Bei Wahl der entgegengesetzten Logikpegel können auch die Kondensatoren 17 und 27 mit ihren entsprechenden Anschlüssen statt auf Masse auf ein positives Potential gelegt werden.

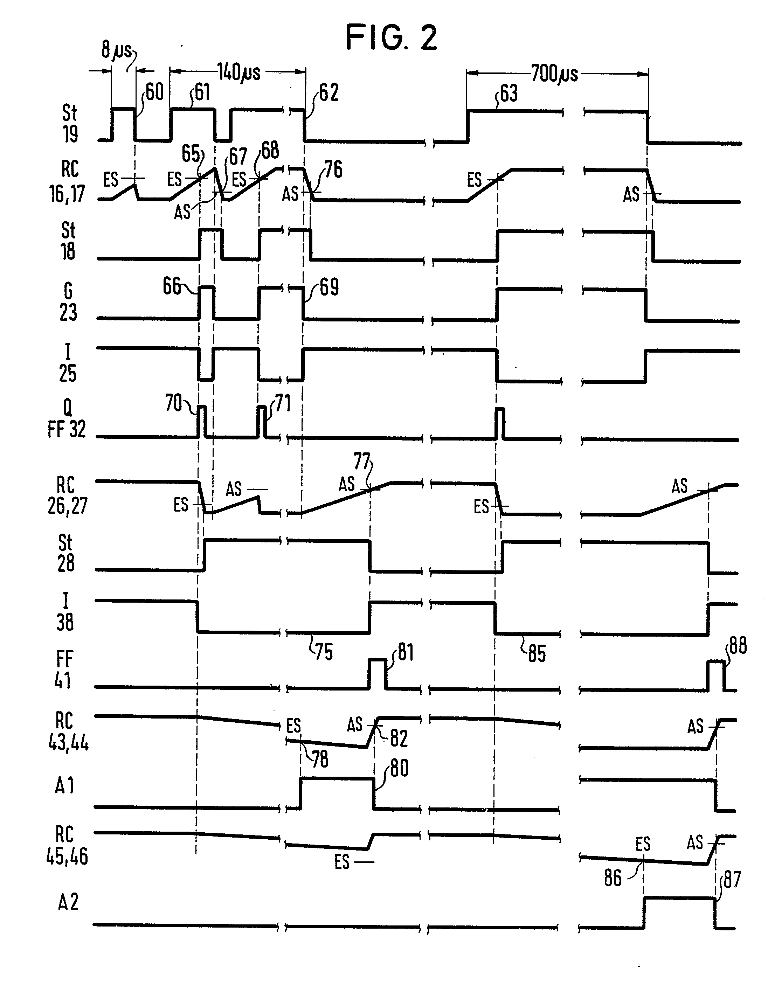

Fig. 2 gibt die Signale wieder, die an verschiedenen Stellen der in Fig. 1 dargestellten Schaltung entstehen, wenn am Eingang E des Impulslängen-Diskriminators zunächst im nutzsignalfreien Zustand ein Störsignal, dann ein durch ein Störsignal "zerhackter" Nutzsignal-Impuls von $140\mu s$ Länge und schließlich ein ungestörter Nutzsignal-Inpuls von $700\mu s$ Länge erscheinen. In der obersten Zeile St 19 der Fig. 2 sind die hierdurch am Ausgang des Schmitt-Triggers 19 entstehenden Signale wiedergegeben. Das im nutzsignalfreien Zustand am Eingang E erscheinende Störsignal erzeugt wegen der oben beschriebenen Wirkung der Klemmdioden-Schaltung 6 am Ausgang des Schmitt-Triggers 19 lediglich einen positiven Spannungsimpuls 60, von dem hier angenommen wird, daß er eine Länge von etwa $8\mu s$ besitzt. Der Nutzsignal-Impuls von $140\mu s$ Länge wird durch die aufgeprägte Störung in zwei Teilimpulse 61 und 62 zerlegt, von denen der erste etwa $15\mu s$ und der zweite etwa $120\ \mu s$ lang ist und die durch eine Impulspause von etwa $5\ \mu s$ Länge voneinander getrennt sind. Der zweite Teilimpuls 62 ist in Fig. 2 stark verkürzt wiedergegeben, was durch die eingezeichnete Unterbrechung angedeutet ist. Auch der wesentlich später folgende zweite Nutzsignal-Impuls 63 von $700\mu s$ Länge ist stark verkürzt wiedergegeben, wobei die dargestellte Unterbrechung einen wesentlich längeren Zeitraum bedeutet als die Unterbrechung im Impuls 62.

Die zweite, mit RC 16, 17 bezeichnete Zeile in Fig. 2 gibt den Spannungsverlauf am Ausgang des RC-Gliedes 16, 17 wieder, der mit dem Eingang des Schmitt-Triggers 18 verbunden ist. Vor Eintreffen des Impulses 60 ist diese Spannung gleich dem Massepotential, da der Schalter 20 geschlossen und somit der Kondensator 17 völlig entladen ist. Durch den Impuls 60 wird der Schalter 20 geöffnet und die Spannung am Ausgang des RC-Gliedes 16, 17 beginnt zu steigen. Da der Impuls 60 jedoch kürzer als der dritte, durch das RC-Glied 16, 17 vorgegebenen Grenzwert $\tau_3$ ist, erreicht, die Spannung am Ausgang des RC-Gliedes 16, 17 die Einschaltschwelle ES des Schmitt-Trigger 18 unverändert auf logisch Null bleibt, wie die Zeile St 18 in Fig. 2 wiedergibt. Durch diese logische Null bleibt das UND-Gatter 23 gesperrt und der Störimpuls 60 wird durch die zweite Impulslängen-Bewertungsschaltung 7 unterdrückt. Sofort nach der fallenden Flanke des Impulses 60 wird der Schalter 20 wieder geschlossen und der Kondensator 17 wird sehr rasch über den Entladewiderstand 21 entladen. Dies ist in der Zeile RC 16, 17 aus Fig. 2 durch den zum Nullpotential hin erfolgenden Spannungsabfall wiedergegeben, der wesentlich steiler als der vorausgehende Spannungsanstieg ist.

Beginnend mit der steigenden Flanke des folgenden ersten Teilimpulses 61 beginnt die Spannung am Ausgang des RC-Gliedes 16, 17 wieder anzusteigen. Da dieser Teilimpuls 61 mit $15\mu s$ Länge größer als der dritte Grenzwert $\tau_3$ ist, erreicht, die Spannung im Punkt 65 die Einschaltschwelle des Schmitt-Triggers 18, der, wie in der Zeile St 18 von Fig. 2 dargestellt, eine logische Eins an den einen Eingang des UND-Gatters 23 legt. Da am anderem Eingang dieses Gatters der Teilimpuls 61 anliegt, erscheint an seinem Ausgang der in der Zeile G 23 dargestellte Impuls 66, der gleichzeitig mit dem ersten Teilimpuls 61 wieder verschwindet. Durch die die beiden Teilimpulse 61 ·

und 62 voneinander trennende Impulspause wird auch der Schalter 20 wieder geschlossen, so daß die Ausgangsspannung des RC-Gliedes 16, 17 rasch abfällt und im Punkt 67 die Ausschaltschwelle AS des Schmitt-Triggers 18 unterschreitet, so daß dieser auch an den von ihm angesteuerten Eingang des UND-Gatters 23 eine logische Null anlegt.

Mit der kurze Zeit später folgenden steigenden Flanke des zweiten Teilimpulses 62 beginnt sich der Kondensator 17 wieder aufzuladen und die Ausgangsspannung des RC-Gliedes 16, 17 überschreitet im Punkt 68 erneut die Einschaltschwelle ES des Schmitt-Triggers 18, der daraufhin an den von ihm angesteuerten Eingang des UND-Gatters 23 wieder eine logische Eins anlegt. Da durch den Teilimpuls 62 auch der andere Eingang des UND-Gatters 23 auf logisch Eins liegt, erscheint am Ausgang dieses Gatters der in der Zeile G 23 wiedergegebenen Impuls 69.

Wie man insbesondere der Zeile G 23 der Fig. 2 entnimmt, verkürzt die zweite Impulslängen-Bewertungsschaltung jeden der ihr zugeführten Eingangsimpulse um etwa $10\mu s$, so daß die ihre beiden Ausgangsimpulse 66 und 69 voneinander trennende Impulspause um etwa $10\mu s$ länger ist, als die Impulspause zwischen den beiden Teilimpulsen 61 und 62. Falls die Verkürzung der durchgelassenen Impulse nicht erwünscht ist, kann erfindungsgemäß z.B. zwischen die zweite Impulslängen-Bewertungsschaltung und die Pausenfalle eine "Regenerierschaltung" eingeschaltet werden, die aus einem Monoflop mit einer Zeitkonstante von $10\mu s$ und einem ODER-Gatter besteht und die durchgelassenen Impulse wieder auf die ursprüngliche Länge bringt, bevor sie der Pausenfalle zugeführt werden.

Die Ausgangssignale des UND-Gatters 23 gelangen über die Signalleitung 24 an den Inverter 25 Pausenfalle 8, der, wie in der Zeile I 25 von Fig. 2 dargestellt, diese Signale einfach invertiert. Außerdem werden die Ausgangssignale des UND-Gatters 23 dem Takteingang des Flip-Flops 32 zugeführt, das durch die steigenden Flanken der Impulse 66 bzw. 69 getriggert wird und daraufhin jeweils an seinem Q-Ausgang einen positiven Impuls 70 bzw. 71 abgibt, dessen zeitliche Länge durch das RC-Glied 33, 34 bestimmt. Durch jeden dieser Impulse wird der Schalter 29 kurzzeitig solange geschlossen, daß der Kon densator 27 auch dann mit Sicherheit vollständig entladen wird, wenn er zuvor vollständig geladen war. Dadurch fällt beim Auftreten des Impulses 70 die in der Zeile RC 26, 27 von Fig. 2 dargestellte Ausgangsspannung des RC-Gliedes 26, 27 von logisch Eins sehr rasch auf logisch Null ab. Die Einschaltschwelle des Schmitt-Triggers 28 liegt hier nur wenig über dem Nullpotential, da es sich bei dem Schmitt-Trigger, 28 um einen invertierenden Schmitt-Trigger handelt. Wenn die Ausgangsspannung des RC-Gliedes 26, 27 diese Einschaltschwelle ES unterschreitet, ändert sich das Ausgangssignal des Schmitt-Triggers 28 von logisch Null auf logisch Eins, wie dies in der Zeile St 28 von Fig. 2 wiedergegeben ist.

In der darunter befindlichen Zeile I 38 ist das Ausgangssignal des Inverters 38 wiedergegeben, das eine einfache Inversion des Ausgangssignals des ODER-Gatters 35 darstellt. Dieses ODER-Gatter empfängt über den unmittelbar mit der Signalleitung 24 verbundenen Eingang den in der Zeile G 23 dargestellten Impuls 66 und gibt diesen praktisch ohne Verzögerung an den Inverter 38 weiter, so daß dessen Ausgangssigal praktisch gleichzeitig mit der steigenden Flanke des Impulses 66 von logisch Eins auf logisch Null schaltet. Da beim Auftreten der fallenden Flanke des Impulses 66 der Schmitt-Trigger 28 den zweiten Eingang des ODER-Gatters 35 auf logisch Eins gelegt hat, bleibt die logische Eins am Ausgang des ODER-Gatters 35 trotz des Verschwindens des Impulses 66 erhalten und das Ausgangssignal des Inverters 38 bleibt unverändert auf logisch Null.

Wie die Zeile RC 26, 27 wiedergibt, beginnt die Ausgangsspannung des RC-Gliedes 26, 27 mit dem Ende des Impulses 66 langsam anzusteigen, da der Kondensator 27 durch die nunmehr am Ausgang des Inverters 25 anliegende logische Eins über den Ladewiderstand 26 langsam aufgeladen wird. Wegen der Kürze der die beiden Impulse 66 und 69 voneinander trennenden Impulspause bleibt aber die bis zum Auftreten des Impulses 71 erreichte Spannung unter der Abschaltschwelle AS des Schmitt-Triggers 28 und die Ausgangsspannung des RC-Gliedes 26, 27 fällt durch das durch den Impuls 71 bewirkte Schließen des Schalters 29 sehr rasch wieder auf logisch Null ab. Der Schmitt-Trigger 28 reagiert also auf die die Impulse 66 und 69 voneinander trennende Impulspause ebensowenig wie das ODER-Gatter 35 und der diesem Gatter nachgeschaltete Inverter 38. Auf der Signalleitung 37 wird also die Reaktion der zweiten Impulslängen-Bewertungsschaltung auf die die beiden Teilimpulse 61 und 62 voneinander trennende Impulspause unterdrückt, so daß am Ausgang der Pausenfalle 8 statt der beiden Teilimpulse 61, 62 ein einziger, ununterbrochener Ausgangsimpuls erscheint, der sich im invertierten Ausgangsimpuls 75 des Inverters 38 wiederspiegelt.

Die fallende Flanke des zweiten Teilimpulses 62 führt zu einem Schließen des Schalters 20, so daß der Kondensator 17 rasch entladen wird und, wie dies Zeile RC 16, 17 darstellt, die Ausgangsspannung des RC-Gliedes 16, 17 im Punkt 76 die Ausschaltschwelle AS des Schmitt-Triggers 18 unterschreitet, dessen Ausgangssignal daraufhin auf logisch Null abfällt. Da der zweite Teilimpuls 62 dem UND-Gatter 23 unmittelbar zugeführt wird, verschwindet dessen Ausgangsimpuls 69 praktisch gleichzeitig mit dem zweiten Teilimpuls 62. Hierdurch springt das Ausgangssignal des Inverters 25 wieder auf logisch Eins und die Ausgangsspannung des RC-Gliedes 26, 27 beginnt langsam anzusteigen, da sich der Kondensator 27 allmählich auflädt. Da auf das Ende des Impulses 62 längere Zeit kein weiterer Impuls folgt, übersteigt die Ausgangsspannung des RC-Gliedes 26, 27 im Punkt 77 die Ausschaltschwelle AS des Schmitt-Triggers 28, dessen Ausgangssignal auf logisch Null abfällt. Da zu diesem Zeitpunkt der dem anderen Eingang des ODER-Gatters 35 zuvor zugeführte Ausgangsimpuls 69 des UND-Gatters 23 längst verschwunden ist, fällt das Ausgangssignal des ODER-Gatters 35 gleichzeitig mit dem des Schmitt-Triggers 28 auf logisch Null und der Inverter 38 schaltet auf logisch Eins, so daß der Impuls 75 beendet ist.

Wie bereits in Verbindung mit Fig. 1 erläutert, werden die Ausgangssignale des Inverters 38 vom nichtinvertierenden Schmitt-Trigger 40 praktisch unverzögert an die Eingänge der beiden RC-Glieder 43, 44 und 45, 46 weitergegeben. Wie die Zeile RC 43, 44 in Fig. 2 zeigt, beginnt die zunächst auf logisch Eins liegende Ausgangsspannung des RC-Gliedes 43, 44 mit dem Auftreten der vorderen Flanke des Impulses 75 langsam abzufallen. Die Zeitkonstante dieses RC-Gliedes 43, 44 ist so groß gewählt, daß seine Ausgangsspanung die Einschaltschwelle ES des nachfolgenden invertierenden Schmitt-Triggers 48 nur dann unterschreitet, wenn der ihm zugeführte Impuls eine zeitliche Länge besitzt, die größer als der eine der beiden vorgegebenen ersten Grenzwerte, nämlich größer als $\tau_{1A} = 120\mu s$ ist. Dieses Überschreiten der Einschaltschwelle ES ist in Fig. 2 in der Zeile RC 43, 44 im Punkt 78 dargestellt. Wie die Zeile A1 zeigt, schaltet in diesem Zeitpunkt der Ausgang A1 der Stufe 3 der ersten Impulslängen-Bewertungsschaltung 1 von logisch Null auf logisch Eins und gibt somit einen Ausgangsimpuls 80 ab, der einer weiteren Verarbeitung zugeführt werden kann.

Mit der vorderen Flanke des Impulses 75 beginnt sich auch der Kondensator 46 des RC-Gliedes 45, 46 aufzuladen, so daß die in der Zeile RC 45, 46 wiedergegebene Ausgangsspannung dieses RC-Gliedes langsam abfällt. Da dessen Zeitkonstante aber gleich dem weiteren ersten Grenzwert $\tau_{1B} = 650\mu s$ gewählt ist, unterschreitet diese Ausgangsspannung die Einschaltschwelle ES des invertierenden Schmitt-Triggers 49 nicht, so daß am Ausgang A2 auf den Impuls 75 keine Reaktion erfolgt.

Die hintere Flanke des Impulses 75 triggert das Flip-Flop 41, das den in der Zeile FF 41 dargestellten Impuls 81 abgibt, dessen zeitliche Länge durch das RC-Glied 56, 57 bestimmt wird und durch den die beiden Schalter 51, 52 geschlossen und somit die Kondensatoren 44 und 46 schnell entladen werden. Die Ausgangsspannunng des RC-Gliedes 43, 44 überschreitet dabei im Punkt 82 die Ausschaltschwelle AS des Schmitt-Triggers 48, dessen Ausgangssignal von logisch Eins auf logisch Null abfällt und damit den Impuls 80 beendet. Die Ausgangsspannung des RC-Gliedes 45, 46 geht auf logisch Eins zurück, ohne daß am Ausgang des invertierenden Schmitt-Triggers 49 eine Reaktion erfolgt.

Insgesamt hat also der erfindungsgemäße Impulslängen-Diskriminator auf den Nutzimpuls von $140\mu s$ Länge in zutreffender Weise durch die Erzeugung eines Ausgangsimpulses 80 am Ausgang A1 reagiert, obwohl dieser Nutzimpuls durch eine Störung in zwei Teilimpulse 61 und 62 "zerhackt" ist, von denen keiner für sich alleine genommen eine ausreichende Länge besitzt, um den durch die Stufe 3 der ersten Impulslängen-Bewertungsschaltung 1 vorgegebenen Grenzwert $\tau_{1A}$ zu überschreiten.

Auf den in der rechten Hälfte der Fig. 2 wiedergegebenen Nutzimpuls 63 von $700\mu s$ Länge reagieren die einzelnen Einheiten der zweiten Impulslängen-Bewertungsschaltung 7 und der Pausenfalle 8 sowie der Inverter 38, der Schmitt-Trigger 40, das Flip-Flop 41 und die Stufe 3 der ersten Impulslängen-Bewertungsschaltung 1 in der gleichen Weise, wie dies oben für den ersten Teilimpuls 61 beschrieben wurde. Insbesondere entsteht am Ausgang des Inverters 38 wieder ein negativer Impuls 85, dessen vordere Flanke gegen die Vorderflanke des Impulses 63 um etwa $10\mu s$ verzögert ist. Beginnend mit der Vorderflanke des Impulses 85 fangen die Kondensatoren 44 und 46 an, aufgeladen zu werden, so daß die Ausgangsspannungen der RC-Glieder 43, 44 und 45, 46 zu fallen beginnen. Dabei unterschreitet zunächst die Ausgangsspannung des RC-Gliedes 43, 44 die Einschaltschwelle des zugehörigen Schmitt-Triggers 48, was in der Zeile RC 43, 44 in Fig. 2 nicht wiedergegeben ist, da dieser Zeitpunkt in den in Fig. 2 nicht dargestellten Zeitraum fällt. Man entnimmt aber der Zeile A1, daß das Ausgangssignal des Schmitt-Triggers 48 nach diesem nicht wiedergegebenen Zeitraum von der zuvor vorhandenen logischen Null auf eine logische Eins angestiegen ist. Wie die Zeile RC 45, 46 der Fig. 2 wiedergibt, dauert der Spannungsabfall am Ausgang des RC-Gliedes 45, 46 beim Impuls 63 bzw. 85 genügend lange, um die Einschaltschwelle des invertierenden Schmitt-Triggers 49 im Punkt 86 zu unterschreiten, so daß nunmehr auch am Ausgang A2 ein Ausgangsimpuls 87 erzeugt wird, der anzeigt, daß dem erfindungsgemäßen Impulslängen-Diskriminator ein Nutzimpuls 63 zugeführt worden ist, dessen zeitliche Länge größer als der weitere vorgegebene erste Grenzwert $\tau_{1B} = 650\mu s$ ist.

Die hintere Flanke des Impulses 85 triggert wiederum das Flip-Flop 41, das daraufhin einen Impuls 88 abgibt, durch den die Schalter 51, 52 geschlossen und somit die Kondensatoren 44, 46 entladen werden. Wenn hierdurch die Ausgangsspannungen der RC-Glieder 43, 44 bzw. 45, 46 die Ausschaltschwellen AS der zugehörigen Schmitt-Trigger übersteigen, schalten die Schmitt-Trigger 48 und 49 wieder auf logisch Null, so daß die Ausgangsimpulse an den Ausgängen A1 und A2 verschwinden.

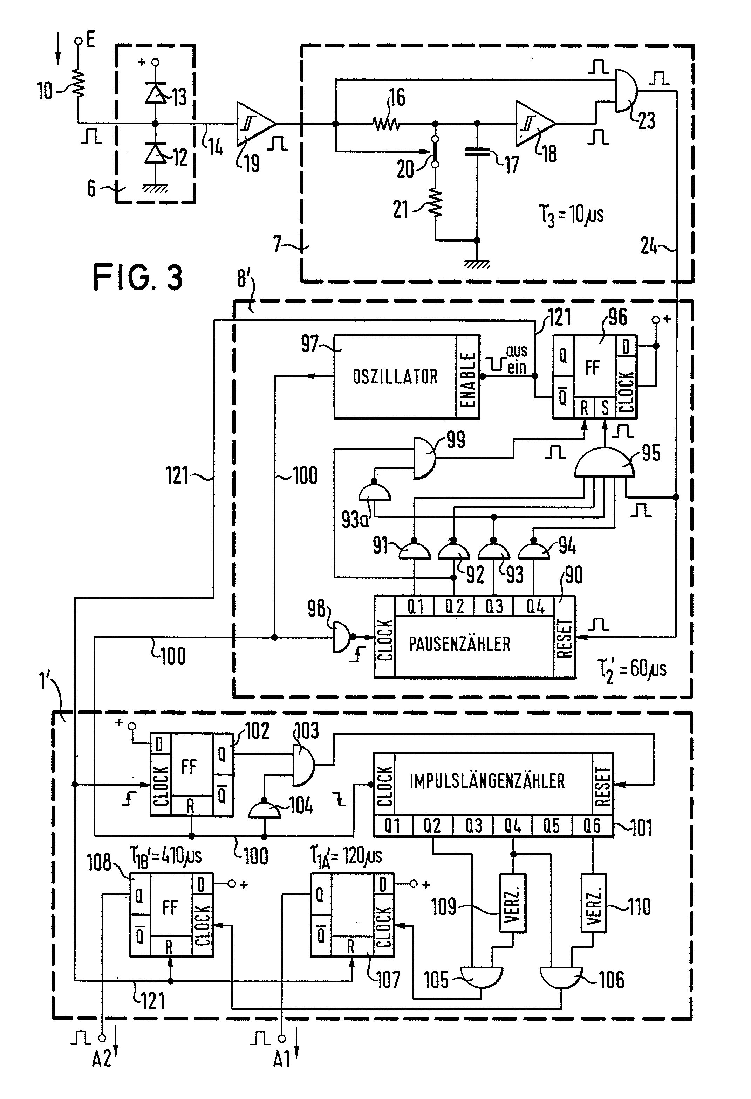

Der in Fig. 3 wiedergegebenen Ausführungsform eines erfindungsgemäßen Impulslängen-Diskriminators werden die am Eingang E erscheinenden Signale ebenfalls über einen Schutzwiderstand 10 zugeführt, der die gleiche Funktion besitzt, wie dies oben für den in Fig. 1 wiedergegebenen Schutzwiderstand 10 beschrieben wurde. Da auch die Dioden-Klemmschaltung 6, der Schmitt-Trigger 19 und die zweite Impulslängen-Bewertungsschaltung 7 denselben Aufbau und dieselbe Funktion besitzen, wie dies für die entsprechenden Schaltungen unter Bezugnahme auf Fig. 1 erläutert wurde, sind hier für gleiche Schaltungselemente die gleichen Bezugszeichen verwendet und es darf zur Vermeidung von Wiederholungen auf die obige Beschreibung verwiesen werden.

Demgegenüber sind die auch hier vorhandene, als Pausenfalle dienende Impulspausen-Bewertungsschaltung 8' und die erste Impulslängen-Bewertungsschaltung 1' als reine Digitalschaltungen aufgebaut.

Die positiven Impulse, die das UND-Gatter 23 auch bei diesem Ausführungsbeispiel über die Signalleitung 24 immer dann abgibt, wenn dem Eingang E ein Impuls mit einer Länge von mehr als $10\mu s$ zugeführt worden ist, setzen einerseits einen Pausenzähler 90 so zurück, daß an seinen vier Ausgängen $Q_1$ bis $Q_4$ jeweils eine logische Null erscheint, die über vier Inverter 91 bis 94 invertiert und als logische Eins an vier Eingänge eines UND-Gatters 95 gelegt werden, dessen fünfter Eingang mit der Leitung 24 verbunden ist. Damit gelangt jeder auf dieser Leitung 24 erscheinende positive Spannungsimpuls an den Ausgang des UND-Gatters 95, der mit dem Setzeingang eines Flip-Flops 96 verbunden ist, das als Speicherschaltung dient, die im nichtgesetzten Zustand ein dem Ruhepotential der Ausgangsimpulse der Pausenfalle 8' entsprechendes Potential, im vorliegenden Fall an seinem $\bar{Q}$-Ausgang eine logische Eins abgibt. Durch den vom UND-Gatter 95 zugeführten Impuls wird dieses Flip-Flop 96 jedoch gesetzt, so daß an sei-

nem $\overline{Q}$ -Ausgang ein dem Arbeitspotential der Ausgangsimpulse der Pausenfalle 8' entsprechendes Potential, nämlich eine logische Null erscheint. Diese logische Null wird dem Enable - Eingang eines Oszillators 97 zugeführt, der hierdurch freigegeben wird und anfängt mit einer vergleichsweise hohen Frequenz, beispielsweise 100 kHz so zu schwingen, daß an seinem Ausgang zunächst für eine Halbperiode von beispielsweise 5 $\mu s$ weiterhin eine logische Null erscheint, auf die dann ein positiver Taktimpuls von 5$\mu s$ Länge folgt, usw. die vom Oszillator 97 erzeugten Taktimpulse gelangen über einen Inverter 98 an den Takteingang des Pausen-Zählers 90, der diese Impulse jedoch solange nicht zählen kann, solange er durch den an seinem Reset-Eingang anliegenden positiven Impuls des UND-Gatters 23 im zurückgesetzten Zustand gehalten wird. Erst wenn dieser Impuls beendet wird, was am Setzeingang des Flip-Flops 96 ohne Wirkung bleibt, wird der Pausen-Zähler 90 freigegeben und beginnt die fallenden Flanken der Taktimpulse des Oszillators 97 zu zählen, die durch den Inverter 98 in steigende Flanken umgekehrt werden. Wenn der Pausen-Zähler 90 den Zählerstand "sechs" erreicht hat, was bei einer Taktfrequenz des Oszillators 97 von 100 kHz einer Zeitkonstante von 60$\mu s$ entspricht, erscheint an seinen Ausgängen $Q_2$ und $Q_3$ jeweils eine logische Eins. Dieser Zählerstand wird mit Hilfe des UND-Gatters 99 abgefragt, das als Decodier-und Rücksetzschaltung dient und bei diesem Zählerstand ein Rücksetzsignal an den Rücksetzeingang des Flip-Flops 96 anlegt. Damit das UND-Gatter 99 nicht bereits beim Zählerstand "vier" versehentlich ein kurzes Signal abgibt, wird ihm die logische Eins vom Ausgang $Q_3$ des Pausen-Zählers 90 nicht direkt sondern über zwei Inverter 93 und 93a zugeführt. Aufgrund des vom UND-Gatter 99 abgegebenen Rücksetzsignals erscheint am $\overline{Q}$ -Ausgang des Flip-Flops 96 eine logische Eins, durch die der Oszillator 97 angehalten wird.

Ist die auf einen auf der Signalleitung 24 erscheinenden positiven Impuls folgende Impulspause jedoch kürzer als 60$\mu s$, so daß der Pausenzähler 90 den Zählerstand "sechs" nicht erreicht, wird der Pausenzähler 90 durch den auf die Pause folgenden Impuls auf der Signalleitung 24 wieder zurückgesetzt, ohne daß das Flip-Flop 96 zurückgesetzt wird. Der Oszillator 97 schwingt somit weiter und gibt seine Taktimpulse weiter über die Leitung 100 an die erste Impulslängen-Bewertungsschaltung 1' ab.

Die Impulslängen-Bewertungsschaltung 1' besitzt auch hier zwei Ausgänge A1 und A2, auf denen sie jeweils dann einen Ausgangsimpuls abgibt, wenn dem Eingang E ein Impuls zugeführt wird, der länger als ein vorgegebener erster Grenzwert $\tau_{1A}'$ = 120$\mu s$ bzw. länger als ein weiterer vorgegebener erster Grenzwert $\tau_{1B}'$ -410$\mu s$ ist.

Um dies zu erkennen, umfaßt die erste Impulsängen-Bewertungsschaltung 1' einen Impulslängenzähler 101, dessen Zähleingang über die Leitung 100 die Taktimpulse des Oszillators 97 empfängt. Diese Taktimpulse gelangen überdies an den Reset-Eingang eines Flip-Flops 102, das durch den ersten dieser Impulse zurückgesetzt wird, so daß an seinem Q-Ausgang eine logische Null erscheint, die ein UND-Gatter 103 sperrt, dessen zweitem Eingang über einen Inverter 104 ebenfalls die Taktimpulse des Oszillators 97 zugeführt werden. Solange jedoch das Flip-Flop 102 zurückgesetzt bleibt, liegt der Ausgang des UND-Gatters 103 auf logisch Null, wodurch der Rücksetzeingang des Impulslängenzälers 101 freigegeben wird. Somit ist dieser Zähler in der Lage, die fallenden Flanken der Taktimpulse des Oszillators 97 beginnened mit dem ersten auf das Erscheinen eines positiven Impulses auf der Signalleitung 24 folgenden Oszillator-Ausgangsimpuls abzuzählen. Die den beiden vorgegebenen ersten Grenzwert $\tau_{1A}'$, bzw. $\tau_{1B}'$ entsprechenden Zählerstände des Impulslängen-Zählers 101 werden über zwei UND-Gatter 105 bzw. 106 abgefragt, die als Dekodier-und Setzschaltungen dienen und jeweils an ein als Speicher schaltung dienendes Flip-Flop 107 bzw. 108 ein Setzsignal abgeben, wenn der Impulslängen-Zähler 101 den durch sie abgefragten Zählerstand erreicht hat. Im Fall des UND-Gatters 105 ist dies der Zählerstand "zehn", der durch das Erscheinen einer logischen Eins an den Ausgängen $Q_2$ und $Q_4$ gekennzeichenet ist. Dieser Zählerstand wird spätetens 100$\mu s$ nach dem Anschwingen des Oszillators 97, d.h. nach der steigenden Flanke eines auf der Signalleitung 24 erscheinenden positiven Impulses erreicht. Da diese Flanke gegen die steifende Flanke des zugehörigen positiven Impulses am Eingang E um etwa 10$\mu s$ verzögert ist, wird hier also insgesamt ein Grenzwert von 110$\mu s$ vorgegeben. Nur wenn dieser Grenzwert durch die Länge eines am Eingang E erscheinenden Impulses überschritten wird, wird das Flip-Flop 107 gesetzt, so daß an seinem mit dem Ausgang A1 verbundenen Q-Ausgang eine logische Eins erscheint.

In entsprechender Weise fragt das UND-Gatter 106 ab, ob der Impulslängen-Zähler 101 den Zählerstand 40 erreicht, was einem weiteren ersten vorgegebenen Grenzwert $\tau_{1B}'$, von 410$\mu s$ entspricht. Nur wenn dieser Grenzwert durch einen am Eingang E erscheinenden Impuls überschritten wird, wird, das Flip-Flop 108 gesetzt, so daß an seinem mit dem Ausgang A2 verbundenen Q-Ausgang eine logische Eins erscheint.

Damit die UND-Gatter 105 und 106 beim ersten Erscheinen einer logischen Eins an den Ausgängen Q₄ bzw. Q₆ nicht bereits vorzeitig ein kurzes Setzsignal an die Flip-Flops 107 bzw. 108 abgeben, sind in den Leitungen, die die Ausgänge Q₄ bzw. Q₆ mit den UND-Gattern 105 bzw. 106 verbinden, Verzögerungsglieder 109 bzw. 110 vorgesehen.

Wenn das Flip-Flop 96 zurückgesetzt wird, weil die nach einem positiven Impuls auf der Leitung 24 auftretende Pause länger als 60μs ist, so wird die hierdurch entstehende logische Eins über eine Leitung 111 einerseits an den Takteingang des Flip-Flops 102 und andererseits an die beiden Reset-Eingänge der Flip-flops 107 und 108 gelegt. Die hierbei am Takteingang des Flip-Flops 102 auftretende steigende Flanke triggert dieses Flip-Flop, das von seinem ständig auf Plus-Potential liegenden Dateneingang D eine logische Eins an seinem Q-Ausgang übernimmt. Damit wird das UND-Gatter 103 freigegeben, so daß die am Ausgang des angehaltenen Oszillators 97 erscheinende logische Null über den Inverter 104 und das UND-Gatter 103 als logische Eins an den Rücksetzeingang des Impulslängen-Zählers 101 gelangen kann, der hierdurch zurückgesetzt wird.

Dies hat folgenden Zweck: Tritt z.B. am Eingang E des Impulslängen-Diskriminators ein positiver Störimpuls auf, der genügend lang ist, um die zweite Impulslängen-Bewertungsschaltung 7 zu überwinden, und folgt auf diesen Störimpuls eine Pause von ca. 30μs Länge bis zum nächsten Stör- oder Nutzimpuls, so ist die steigende Flanke dieses nachfolgenden Impulses in keiner Weise mit den Taktimpulsen des Oszillators korreliert, der durch den ersten dieser beiden Impulse freigegeben wurde. Es kann daher geschehen, daß die steigende Flanke des zweiten Impulses, der am Ausgang des UND-Gatters 23 um weitere 10μs verzögert erscheint, unmittelbar auf den Zeitpunkt folgt, in dem der Pausen-Zähler 90 den Zählwert "sechs" erreicht hat. Hierdurch wird das Flip-Flop 96 nur für ganz kurze Zeit zurückgesetzt und dann sofort wieder gesetzt. Der Oszillator 97 reagiert auf den hierdurch entstehenden, äußerst kurzen Ausgangsimpuls am $\overline{Q}$ -Ausgang des Flip-Flops 96 praktisch nicht, sondern schwingt weiter, wobei nur die Pause zwischen den zwei betreffenden Taktimpulsen etwas länger als 5μs wird. Würde man die Ausgangsimpulse des $\overline{Q}$ -Ausgangs von Flip-Flop 96 dem Rücksetzeingang des Impulslängenzählers 101 direkt zuführen, so würde die Gefahr bestehen, daß dieser durch einen sehr kurzen Ausgangsimpuls der eben beschriebenen Art nicht oder nicht vollständig zurückgesetzt wird und daher die Länge des nächsten Impulses falsch bewertet.

Bei der erfindungsgemäßen Anordnung wird das Flip-Flop 102 aber in jedem Fall durch die steigende Flanke gesetzt, die der $\overline{Q}$ -Ausgang des Flip-Flops 96 abgibt, wenn dieses Flip-Flop 96 beim Erreichen des Zählerstandes "sechs" durch den Pausenzähler 90 zurückgesetzt wird. Da dieser Zählerstand beim Auftreten einer fallenden Flanke eines Taktimpulses erreicht wird, und da der Oszillator 97 auch beim sofortigen Neuanschwingen zunächst für eine Halbperiode einen "Low"-Pegel abgibt, der durch den Inverter 104 in eine logische Eins umgekehrt und von dem UND-Gatter 103, das durch das gesetzte Flip-flop 102 freigegeben ist, an den Rücksetzeingang des Impulsbreitenzählers 101 gelegt wird, erhält dieser Zähler in jedem Fall ein Rücksetzsignal, das wenigstens eine der halben Periodenlänge des Taktsignals des Oszillators 97 entsprechende Länge besitzt und somit für ein einwandfreies, vollständiges Zurücksetzen ausreicht.

Die logische Eins auf der Leitung 111 setzt überdies die beiden Flip-Flops 107 und 108 zurück, so daß eine gegebenenfalls an ihren Q-Ausgängen vorhandene logische Eins verschwindet und die Ausgänge A1 und A2 wieder signalfrei werden.

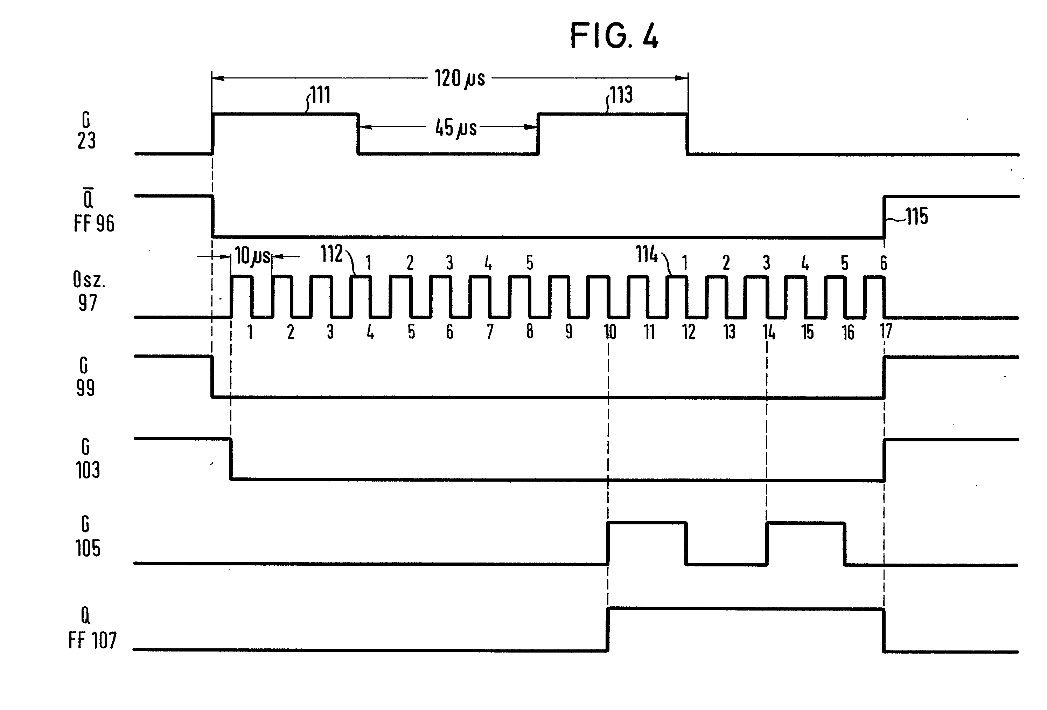

Die Funktionsweise des in Fig. 3 dargestellten Ausführungsbeispiels eines erfindungsgemäßen Impulslängen-Diskriminators wird im folgenden anhand des in Fig. 4 wiedergegebenen Impulsdiagramms erläutert. Da die in Fig. 3 wiedergegebene Dioden-Klemmschaltung 6 und die ihr nachgeschaltete zweite Impulslängen-Bewertungsschaltung 7 den gleichen Aufbau und die gleiche Funktion besitzen, wie die entsprechenden Schaltungen aus Fig. 1, ist der Signalverlauf in diesen Schaltungen in Fig. 4 nicht nochmals dargestellt. Die oberste Zeile G 23 der Fig. 4 stellt vielmehr bereits einen auf der Signalleitung 24 erscheinenden Ausgangsimpuls des UND-Gatters 23 der zweiten Impulslängen-Bewertungsschaltung 7 dar, von dem angenommen wird, daß er eine Gesamtlänge von 120μs besitzt und durch eine auf einer Störung beruhenden Impulspause von 45μs Länge in zwei Teilimpulse 111 und 113 "zerhackt" wird.

Wie die zweite Zeile von Fig. 4 zeigt, wird durch das Auftreten des ersten Teilimpulses 111 am Ausgang des UND-Gatters 23 das Flip-Flop 96 gesetzt, so daß sein $\overline{Q}$ -Ausgang von logisch Eins auf logisch Null schaltet.

Hierdurch wird der Oszillator 97 freigegeben, so daß er zu schwingen beginnt und eine Vielzahl von Impulsen erzeugt, deren Periodenlänge 10μs beträgt.

Der Pausenzähler 90, von dem angenommen wird, daß er aufgrund der dem Auftreten des Teilimpulses 111 vorausgehenden Impulsverarbeitung auf dem Zählwert "sechs" steht, wird durch den Teilimpuls 111 zurückgesetzt, so daß das Signal am Ausgang des UND-Gatters 99, das den Zählerstand "sechs" abfragt, von logisch Eins auf logisch Null übergeht, wie dies in der Zeile G 99 von Fig. 4 dargestellt ist. Solange der erste Teilimpuls 111 am Reset-Eingang des Pausenzählers 90 anliegt, wird dieser daran gehindert, die Taktimpulse des Oszillators 97 zu zählen. Diese Zählung beginnt erst nach dem Verschwinden des ersten Teilimpulses 111 mit dem Taktimpuls 112. Dabei reagiert der Pausenzähler 90 auf die fallenden Flanken der in Fig. 4 wiedergegebenen Taktimpulse, da ihm das Ausgangssignal des Oszillators 97 über den Inverter 98 zugeführt wird und sein Takteingang auf steigende Impulsflanken anspricht. Die vom Pausenzähler 90 erreichten Zählwerte sind in der Zeile Osz. 97 von Fig. 4 über den betreffenden fallenden Flanken wiedergegeben. Man sieht, daß der Pausenzähler 90 nur den Zählwert "fünf" erreicht, da dann der zweite Teilimpuls 113 auftritt und den Pausenzähler 90 zurücksetzt. Die beiden von der Impulspausen-Unterdrückungsschaltung 8' an die nachfolgende erste Impulslängen-Bewertungsschaltung 1' abgegebenen Signale, nämlich das Signal am $\overline{Q}$-Ausgang des Flip-flops 96 und die vom Oszillator 97 abgegebenen Taktsignale reagieren auf die 45μs lange Pause zwischen den beiden Teilimpulsen 111 und 113 nicht, so daß diese Pause unterdrückt wird und von der ersten Impulslängen-Bewertungsschaltung 1' nicht wahrgenommen werden kann. Vielmehr arbeitet diese erste Impulsängen-Bewertungsschaltung, wie weiter unten noch genauer erläutert wird, so, als ob auf der Signalleitung 24 ein einziger, ununterbrochener Impuls von 120μs Länge aufgetreten wäre.

Bei Beendigung des zweiten Teilimpulses 113 wird, wie dies oben für das Ende des ersten Teilimpulses 111 beschrieben wurde, der Pausenzähler 90 wieder freigegeben, so daß er beginnend mit dem Taktimpuls 114 erneut die vom Oszillator 97 erzeugten Taktimpulse abzählt. Die hierbei erreichten Zählwerte sind in der Zeile Osz. 97 von Fig. 4 wieder über den entsprechenden fallenden Flanken angeschrieben.

Da auf den zweiten Teilimpuls 113 für einen genügend langen Zeitraum kein weiterer Impuls auf der Signalleitung 24 erscheint, kann der Pausenzähler 90 nunmehr den Zählerstand "sechs" erreichen, der durch UND-Gatter 99 abgefragt wird.

Wie die Zeile G 99 von Fig. 4 zeigt, schaltet mit der fallenden Flanke des sechsten abgezählten Oszillatorimpulses der Ausgang des UND-Gatters 99 auf logisch Eins, wodurch das Flip-Flop 96 zurückgesetzt wird, so daß das Signal an seinem $\overline{Q}$-Ausgang auf logisch Eins ansteigt. Die hierbei erzeugte steigende Flanke ist in Fig. 4 mit dem Bezugszeichen 115 gekennzeichnet. Durch die auf die Flanke 115 am Q-Ausgang des Flip-Flops 96 folgende logische Eins wird der Oszillator 97 angehalten, so daß auf den den Zählwert "sechs" erzeugenden Taktimpuls zunächst keine weiteren Taktimpulse mehr folgen. Die logische Eins am Ausgang des Gatters 99 bleibt solange erhalten, bis der Pausenzähler 90 durch den nächsten auf der Signalleitung 24 erscheinenden positiven Impuls zurückgesetzt wird, so daß an jedem seiner Zählausgänge $Q_1$ bis $Q_4$ eine logische Null erscheint.

Wie man der Zeile G 103 von Fig. 4 entnimmt, geht der Logikpegel am Ausgang des UND-Gatters 103 der ersten Impulslängen-Bewertungsschaltung 1' nach dem Auftreten des ersten Teilimpulses 111 von logisch Eins auf logisch Null über, wenn das zuvor gesetzte Flip-Flop 102 durch den High-Pegel des ersten Taktimpulses des Oszillators 97 zurückgesetzt wird, wodurch an seinem das UND-Gatter 103 ansteuernden Q-Ausgang eine logische Null erscheint. Durch das Verschwinden der logischen Eins am Ausgang des UND-Gatters 103 wird der Rücksetzeingang des Impulslängen-Zählers 101 freigegeben, der beginnend mit dem ersten von Oszillator 97 erzeugten Taktimpuls die fallenden Flanken dieser Taktimpulse abzählt. Die hierbei vom Impulslängen-Zähler 101 erreichten Zählwerte sind in der Zeile Osz. 97 von Fig. 4 unter den betreffenden Fallenden Flanken angeschrieben.

Das den Zählerstand "zehn" abfragende UND-Gatter 105 schaltet bei der fallenden Flanke des zehnten gezählten Impulses von logisch Null auf logisch Eins (siehe Zeile G 105 von Fig. 4) und setzt mit der hierbei entstehenden steigenden Flanke das Flip-Flop 107, so daß an dessen Q-Ausgang und damit am Ausgang A1 des Impulslängen-Diskriminators eine logische Eins erscheint, wie dies in der untersten Zeile von Fig. 4 dargestellt ist.

Die logische Eins am Ausgang des UND-Gatters 105 bleibt auch noch beim elften Taktimpuls des Oszillators 97 erhalten und verschwindet erst wieder beim zwölften Taktimpuls. Außerdem spricht das UND-Gatter 105 nochmals bei der fallenden Flanke des vierzehnten gezählten Taktimpulses an. Da das Flip-Flop 107 zu diesem Zeitpunkt aber noch gesetzt ist, bleibt die zugehörige steigende Flanke am Ausgang des UND-Gatters 105 ohne Wirkung.

Durch die steigende Flanke 115, die am $\overline{Q}$ - Ausgang des Flip-Flops 96 auftritt, wenn der Pausenzähler 90 den Zählwert "sechs" erreicht hat, wird einerseits das Flip-Flop 102 gesetzt, so daß an seinem Q-Ausgang eine logische Eins erscheint was in Verbindung mit der gleichzeitig am Taktausgang des Oszillators 97 erscheinenden logischen Null, die durch den Inverter 104 in eine logische Eins umgesetzt wird, am Ausgang des UND-Gatters 103 zu einer logischen Eins führt. Durch diese logische Eins wird der Impulslängen-Zähler 101 zurückgesetzt. Außerdem wird durch die steigende Flanke 115 das Flip-Flop 107 zurückgesetzt, so daß an seinem Q-Ausgang die logische Eins verschwindet.

Da bei dem in Fig. 4 wiedergegebenen Beispiel ein Impuls von insgesamt 120μs Länge angenommen wurde, erreicht der Impulslängen-Zähler den von UND-Gatter 106 abgefragten Zählerstand "vierzig" nicht, so daß das UND-Gatter 106 und das ihm nachgeschaltete Flip-Flop 108 in diesem Fall nicht ansprechen. Im Prinzip arbeiten diese beiden Schaltungen aber in der gleichen Weise, wie dies eben für das UND-Gatter 105 und das Flip-Flop 107 beschrieben wurde.

## Ansprüche

1. Impulslängen-Diskriminator mit einer Impulslängen-Bewertungsschaltung, die eine Vielzahl von elektrischen Impulsen empfängt, bei deren Auftreten das Potential am Eingangsanschluß des Impulslängen-Diskriminators jeweils von einem Ruhepotential auf ein Arbeitspotential und dann wieder zurück auf das Ruhepotential übergeht, und die wenigstens eine Impulslängen-Bewertungsstufe umfaßt, welche die zeitliche Länge von Einzelimpulsen bewertet und nur dann ein Ausgangssignal abgibt, wenn die zeitliche Länge eines empfangenen Impulses größer als wenigstens ein erster vorgebbarer Grenzwert ist, dadurch **gekennzeichnet,** daß der Impulslängen-Bewertungsschaltung (1, 1') eine Störsignal-Unterdrückungsanordnung vorgeschaltet ist.

2. Impulslängen-Diskriminator nach Anspruch 1, dadurch **gekennzeichnet,** daß die Störsignal-Unterdrückungsanordnung eine Impulspausen-Bewertungsschaltung (8; 8') umfaßt.

3. Impulslängen-Diskriminator nach Anspruch 2, dadurch **gekennzeichnet,** daß die Impulspausen-Bewertungsschaltung (8; 8') alle Impulspausen unterdrückt, deren zeitliche Länge kleiner als ein zweiter vorgebbarer Grenzwert ($\tau_2$) ist, der kleiner als der erste Grenzwert ($\tau_{1A}$, $\tau_{1B}$) ist.

4. Impulslängen-Diskriminator nach Anspruch 2 oder 3, dadurch **gekennzeichnet,** daß die Störsignal-Unterdrückungsanordnung weiterhin eine der Impulspausen-Bewertungsschaltung (8; 8') vorgeschaltete zweite Impulslängen-Bewertungsschaltung (7) umfaßt, die nur dann einen Ausgangsimpuls erzeugt, wenn die zeitliche Länge eines ihr zugeführten Eingangsimpulses einen vorgebbaren dritten Grenzwert ($\tau_3$) übersteigt, der kleiner als der zweite Grenzwert ($\tau_2$) ist.

5. Impulslängen-Diskriminator nach Anspruch 4, dadurch **gekennzeichnet,** daß der zweite Grenzwert ($\tau_2$) etwa 50 % und der dritte Grenzwert ($\tau_3$) etwa 10 % des kleinsten der vorgebbaren ersten Grenzwerte ($\tau_{1A}$, $\tau_{1B}$) beträgt.

6. Impulslängen-Diskriminator nach einem der vorhergehenden Ansprüche, dadurch **gekennzeichnet,** daß das Eingangsglied der Störsignal-Unterdrückungsanordnung ein Schmitt-Trigger (19) ist, dessen Einschaltschwelle nahe am Arbeitspotential gewählt ist.

7. Impulslängen-Diskriminator nach einem der vorhergehenden Ansprüche, dadurch **gekennzeichnet,** daß die Störsignal-Unterdrückungsanordnung weiterhin eine Potential-Klemmschaltung (6) umfaßt, die verhindert, daß das Potential am Signaleingang (E) der Störsignal-Unterdrückungsanordnung in der dem Arbeitspotential entgegen gesetzten Richtung über einen vorgebbaren ersten Spannungsgrenzwert hinaus vom Ruhepotential abweicht.

8. Impulslängen-Diskriminator nach Anspruch 7, dadurch **gekennzeichnet,** daß die Potential-Klemmschaltung (6) verhindert, daß das Potential am Signaleingang (E) der Störsignal-Unterdrückungsanordnung in Richtung des Arbeitspotentials über einen vorgebbaren zweiten Spannungsgrenzwert hinaus vom Ruhepotential abweicht.

9. Impulslängen-Diskriminator nach Anspruch 8, dadurch **gekennzeichnet,** daß der vorgebbare erste Spannungsgrenzwert gleich dem Ruhepotential und der zweite vorgebbare Spannungsgrenzwert gleich dem Arbeitspotential ist.

10. Impulslängen-Diskriminator nach Anspruch 9, dadurch **gekennzeichnet,** daß die Potential-Klemmschaltung (6) aus zwei Dioden (12, 13) besteht, von denen die eine (12) mit ihrer Anode auf das Ruhepotential gelegt und mit ihrer Kathode mit dem Signaleingang (E) der Störsignal-Unterdrückungsanordnung verbunden ist, und von denen die andere (13) mit ihrer Anode mit dem Signaleingang (E) der Störsignal-Unterdrückungsanordnung verbunden und mit ihrer Kathode auf das Arbeitspotential gelegt ist.

11. Impulslängen-Diskriminator nach einem der vorhergehenden Ansprüche, dadurch **gekennzeichnet,** daß die zweite Impulslängen-Bewertungsschaltung (7) ein Verzögerungsglied, dessen Zeitkonstante im wesentlichen den vorgebbaren dritten Grenzwert ($\tau_3$) bestimmt und ein UND-Gatter umfaßt, daß dem Eingang des Verzögerungsgliedes und dem einen der beiden Eingänge des UND-Gatters die Eingangsimpulse für die zweite Impulslängen-Bewertungsschaltung - (7) zugeführt werden, daß der Ausgang des Verzögerungsgliedes den zweiten Eingang des UND-Gatters ansteuert und daß die Ausgangsimpulse des UND-Gatters die Ausgangsimpulse der zweiten Impulslängen-Bewertungsschaltung sind.

12. Impulslängen-Diskriminator nach einem der Ansprüche 1 bis 11, dadurch **gekennzeichnet,** daß der zeitbestimmende Teil der zweiten Impulslängen-Bewertungsschaltung (7) als Analogschaltung aufgebaut ist.

13. Impulslängen-Diskriminator nach Anspruch 12, dadurch **gekennzeichnet,** daß die zweite Impulslängen-Bewertungsschaltung (7) als zeitbestimmenden Teil ein integrierendes RC-Glied (16, 17) umfaßt, dem die zu bewertenden Impulse zugeführt werden, dessen Ausgangsspannung an den Eingang eines Schmitt-Triggers (18) gelegt ist und dessen Zeitkonstante den dritten Grenzwert ($\tau_3$) im wesentlichen bestimmt.

14. Impulslängen-Diskriminator nach Anspruch 13, dadurch **gekennzeichnet,** daß parallel zum Kondensator (17) des RC-Gliedes (16, 17) der zweiten Impulslängen-Bewertungsschaltung (7) eine steuerbarer Schalter (20) und ein mit diesem Schalter (20) in Reihe liegender Entladewiderstand (21) angeordnet sind, dessen Widerstandswert wesentlich kleiner als der Widerstandswert des Ladewiderstands (16) des RC-Gliedes (16, 17) ist, und daß der Schalter (20) in den Zeiten, in denen der zweiten Impulslängen-Bewertungsschaltung (7) kein Eingangsimpuls zugeführt wird, geschlossen und beim Anliegen eines solchen Eingangsimpulses geöffnet ist.

15. Impulslängen-Diskriminator nach Anspruch 14, dadurch **gekennzeichnet,** daß die zweite Impulslängen-Bewertungsschaltung (7) ein UND-Gatter (23) umfaßt, dessen einer Eingang mit dem Ausgang des Schmitt-Triggers (18) und dessen zweiter Eingang mit dem Eingang des RC-Gliedes (16, 17) verbunden ist.

16. Impulslängen-Diskriminator nach einem der Ansprüche 3 bis 15, dadurch **gekennzeichnet,** daß der zeitbestimmende Teil der Impulspausen-Bewertungsschaltung (8) als Analogschaltung aufgebaut ist.

17. Impulslängen-diskriminator nach Anspruch 16, dadurch **gekennzeichnet,** daß die Impulspausen-Bewertungsschaltung (8) als zeitbestimmenden Teil ein integrierendes RC-Glied (26, 27) umfaßt, dem die Eingangsimpulse für die Impulspausen-Bewertungsschaltung (8) zugeführt werden, dessen Ausgangsspannung an den Eingang eines Schmitt-Triggers (28) angelegt ist und dessen Zeitkonstante den zweiten Grenzwert - ($\tau_2$) im wesentlichen bestimmt.

18. Impulslängen-Diskriminator nach Anspruch 17, dadurch **gekennzeichnet,** daß parallel zum Kondensator (27) des RC-Gliedes (26, 27) der Impulspausen-Bewertungsschaltung (8) ein steuerbarer Schalter (29) und ein mit diesem Schalter - (29) in Reihe liegender Entladewiderstand (30) angeordnet sind, dessen Widerstandswert wesentlich kleiner als der Widerstanswert des Ladewiderstandes (26) des RC-Gliedes (26, 27) ist, und daß der Schalter (29) geöffnet ist und nur bei Beginn eines jeden der Impulspausen-Bewertungsschaltung (8) zugeführten Eingangsimpulses für einen Zeitraum ist, in dem der Kondensater (27) über den Entladewiderstand (30) aus dem Zustand maximaler Ladung vollständig entladen werden kann.

19. Impulslängen-Diskriminator nach Anspruch 18, dadurch **gekennzeichnet,** daß der Ausgang des Schmitt-Triggers (28) der Impulspausen-Bewertungschaltung (8) mit dem einen Eingang eines ODER-Gatters (35) verbunden ist, dessen zweitem Eingang die Eingangsimpulse für die Impulspausen-Bewertungsschaltung (8) direkt zugeführt werden.

Impulslängen-Diskriminator nach einem der vorhergehenden Ansprüche, dadurch **gekennzeichnet,** daß die wenigstens eine Impulslängen-Bewertungsstufe der ersten Impulslängen-Bewertungsschaltung (1) ein Verzögerungsglied, dessen Zeitkonstante im wesentlichen den wenigstens einen ersten Grenzwert ($\tau_{1A}$; $\tau_{1B}$) bestimmt, und ein UND-Gatter umfaßt, daß dem Eingang des Verzögerungsgliedes und einem der beiden Eingänge des UND-Gatters die Eingangsimpulse für die wenigstens eine Impulslängen-Bewertungsstufe zugeführt werden, daß der Ausgang des Verzögerungsgliedes den zweiten Eingang des UND-Gatters ansteuert, und daß die Aus gangsimpulse des UND-Gatters die Ausgangsimpulse der wenigstens einen Impulslängen-Bewertungsstufe sind.

21. Impulslängen-Diskriminator nach einem der Anspruche 1 bis 19, dadurch **gekennzeichnet,** daß der zeitbestimmende Teil der ersten Impulslängen-Bewertungsschaltung (1) als Analogschaltung aufgebaut ist.

22. Impulslängen-Diskriminator nach Anspruch 21, dadurch **gekennzeichnet,** daß die wenigstens eine Impuls längen-Bewertungstufe (3; 4) der ersten Impulslängen-Bewertungsschaltung (1) als zeitbestimmenden Teil ein integrierendes RC-Glied (43, 44; 45, 46) umfaßt, dem die Eingangsimpulse für die Impulslängen-Bewertungsstufe (3; 4) zugeführt werden, dessen Ausgangsspannung an den Eingang eines Schmitt-Triggers (48; 49) angelegt ist, und dessen Zeitkonstante den wenigstens einen ersten Grenzwert ($\tau_{1A}$ ; $\tau_{1B}$) im wesentlichen bestimmt.

23. Impulslängen-Diskriminator nach Anspruch 22, dadurch **gekennzeichnet,** daß parallel zum Kondensator (44; 46) des RC-Gliedes (43, 44; 45, 46) der wenigstens einen Impulslängen-Bewertungsstufe (3; 4) ein steuerbarer Schalter (51; 52) und ein mit diesem Schalter (51; 52) in Reihe liegender Entladewiderstand (53; 54) angeordnet sind, dessen Widerstandswert wesentlich kleiner als der Widerstandswert des Ladewiderstandes (43; 45) des RC-Gliedes (43, 44; 45, 46) ist, und daß der Schalter (51; 52) normalerweise geöffnet ist bei Beendigung eines jeden der ersten Impulslängen-Bewertungsschaltung (1) zugeführten Eingangsimpulses für einen bestimmten Zeitraum geschlossen wird, der größer als der Zeitraum ist, in dem der Kondensator (44; 46) über den Entladewiderstand - (53; 54) aus dem Zustand maximaler Ladung vollständig entladen werden kann.

24. Impulslängen-Diskriminator nach Anspruch 22 oder 23, dadurch **gekennzeichnet,** daß die erste Impulslängen-Bewertungsschaltung (1) einen weiteren Schmitt-Trigger (40) umfaßt, dem die Eingangsimpulse für die erste Impulslängen-Bewertungsschaltung (1) zugeführt werden und dessen Ausgang mit dem Eingang des RC-Gliedes (43, 44; 45, 46) der wenigstens einen Impulslängen-Bewertungsstufe (3; 4) verbunden ist.

25. Impulslängen-Diskriminator nach einem der Ansprüche 1 bis 15, dadurch **gekennzeichnet,** daß die zeitbestimmenden Teile der ersten Impulslängen-Bewertungsschaltung (1') und/oder der Impulspausen-Bewertungsschaltung (8') als Digitalschaltungen aufgebaut sind.

26. Impulslängen-Diskriminator nach Anspruch 25, dadurch **gekennzeichnet,** daß die Impulspausen-Bewertungsschaltung (8') folgende Bestandteile umfaßt:

-Eine Speicherschaltung (96) , die im nichtgesetzten Zustand ein dem Ruhepotential der Ausgangsimpulse der Impulspausen-Bewertungsschaltung (8') entsprechendes Potential und im gesetzten Zustand ein dem Arbeitspotential der Ausgangsimpulse der Impulspausen-Bewertungsschaltung (8') entsprechendes Potential abgibt und die jeweils beim Auftreten eines Eingangsimpulses für die Impulspausen-Bewertungsschaltung (8') gesetzt wird,

-einen Pausenzähler (90), der jeweils am Ende eines der Impulspausen-Bewertungsschaltung (8') zugeführten Eingangsimpulses beginnt, die Taktimpulse eines Oszillators (97) abzuzählen, und

-eine Dekodier-und Rücksetzschaltung (99), die die Speicherschaltung (96) erst dann zurücksetzt, wenn der Zählerstand des Pausenzählers (90), einen vorgebbaren Wert erreicht hat, der den zweiten Grenzwert ($\tau_2'$) im wesentlichen bestimmt.

27. Impulslängen-Diskriminator nach Anspruch 25 oder 26, dadurch **gekennzeichnet,** daß die erste Impulslängen-Bewertungsschaltung (1') folgende Bestandteile umfaßt:

-Einen Impulslängenzähler (101), der jeweils am Anfang eines der ersten Impulslängen-Bewertungsschaltung (1') zugeführten Signalimpulses beginnt, die Taktimpulse eines Oszillators (97) abzuzählen,

-Wenigstens eine Dekodier-und Setzschaltung - (105; 106) die ein Setzsignal erzeugt, wenn der Zählerstand des Im pulslängenzählers (101) einen vorgebbaren Wert erreicht hat, der den wenigstens einen ersten Grenzwert ($\tau_{1A}'$; $\tau_{1B}'$) im wesentlichen bestimmt, und

-eine Speicherschaltung (107; 108) die im gesetzten Zustand ein Ausgangssignal der ersten Impulslängen-Bewertungsschaltung (1') erzeugt und die durch das Setzsignal der Dekodier-und Setzschaltung (105; 106) gesetzt und durch das Ende eines jeden der Impulslängen-Bewertungsschaltung (1') zugeführten Signalimpulses zurückgesetzt wird.

28. Impulslängen-Diskriminator nach Anspruch 26 und 27, dadurch **gekennzeichnet,** daß der Pausenzähler (90) und der Impulsbreitenzähler (101) die Taktimpulse desselben Oszillators (97) abzählen, daß der Oszillator (97) nur dann zur Erzeugung von Taktimpulsen freigegeben wird, wenn der Impulspausen-Bewertungsschaltung (8') ein Eingangsimpuls zugeführt worden ist, und daß der Oszillator (97) nach Beendigung dieses Eingangsimpulses jeweils nur solange weiterschwingt, bis die Dekodier-und Rücksetzschaltung (99) der Impulspausen-Bewertungsschaltung (8') ein Rücksetzsignal abgibt.

29. Impulslängen-Diskriminator nach einem der vorhergehenden Ansprüche, dadurch **gekennzeichnet,** daß dem Signaleingang (E) der Störsignal-Unterdrückungsanordnung ein seriell in der weiterführenden Signalleitung (14) liegendes Strombegrenzungselement (10) nachgeschaltet ist.

FIG. 1

# FIG. 2

0 236 840

FIG. 3

# FIG. 4

0 236 840